# EUROPEAN PATENT APPLICATION

(11) **EP 4 764 769 A1**
(43) Date of publication of application: **24.06.2026**
(21) Application number: 24863100.4
(22) Date of filing: 26.08.2024
(51) Int. Cl.: G06F 1/16

(54) **ELECTRONIC DEVICE INCLUDING HINGE**

(30) Priority: 08.09.2023 KR 20230119759; 10.10.2023 KR 20230134459
(71) Applicant: Samsung Electronics Co., Ltd., Suwon-si, Gyeonggi-do 16677 (KR)
(72) Inventor: YOON, Yeonggyu, Suwon-si, Gyeonggi-do 16677 (KR); KANG, Jeongho, Suwon-si, Gyeonggi-do 16677 (KR); KIM, Namwoo, Suwon-si, Gyeonggi-do 16677 (KR); KIM, Minho, Suwon-si, Gyeonggi-do 16677 (KR); PARK, Changi, Suwon-si, Gyeonggi-do 16677 (KR); AHN, Jaeuk, Suwon-si, Gyeonggi-do 16677 (KR); JUNG, Soli, Suwon-si, Gyeonggi-do 16677 (KR); CHOI, Junyoung, Suwon-si, Gyeonggi-do 16677 (KR); HONG, Hyunchul, Suwon-si, Gyeonggi-do 16677 (KR); YOON, Byounguk, Suwon-si, Gyeonggi-do 16677 (KR)
(74) Representative: Nederlandsch Octrooibureau
(86) International application number: PCT/KR2024/012720
(87) International publication number: WO 2025/053519

(57) **Abstract**

The present invention relates to an electronic device. The electronic device according to an embodiment of the present invention comprises: a first housing; a second housing rotatably disposed relative to the first housing; a flexible display seated in the first housing and the second housing; and a hinge assembly rotatably connecting the first housing and the second housing. The hinge assembly may include: a hinge housing that includes a base plate, a first sidewall projecting from the base plate, and a second sidewall projecting from the baseplate and spaced apart from the first sidewall; a first rotator coupled to the first housing and rotatably connected to the hinge housing; a second rotator coupled to the second housing and rotatably connected to the hinge housing; and a first link which is connected to the first rotator and at least a portion of which is movably positioned between the first sidewall and the second sidewall.

## Description

### [Technical Field]

Various embodiments disclosed herein relate to an electronic device, for example, an electronic device including a hinge.

### [Background Art]

With the remarkable development of information communication technology, semiconductor technology, and the like, the distribution and use of various electronic devices are rapidly increasing. In particular, recent electronic devices are being developed to be portable and capable of communication.

The term "electronic device" may refer to a device that performs a specific function according to an installed program, such as a home appliance, an electronic scheduler, a portable multimedia player, a mobile communication terminal, a tablet PC, an image and sound device, a desktop or laptop PC, or a vehicle navigation system. For example, these electronic devices may output stored information as sound or images. As the degree of integration of electronic devices increases and ultra-high-speed and high-capacity wireless communication become more widespread, a single electronic device, such as a mobile communication terminal, may be now equipped with various functions. For example, not only communication functions but also entertainment functions such as gaming, multimedia functions such as music and video playback, communication and security functions such as mobile banking, as well as schedule management and electronic wallet functions, are being integrated into a single electronic device. Such an electronic device is being miniaturized to allow a user to conveniently carry it.

### [Detailed Description of the Invention]

### [Technical Solution]

According to an embodiment of the disclosure, an electronic device may include a first housing, a second housing disposed to be rotatable with respect to the first housing, a flexible display seated on the first housing and the second housing, and a hinge assembly rotatably connecting the first housing and the second housing. The hinge assembly may include a hinge housing including a base plate, a first side wall protruding from the base plate, and a second side wall protruding from the base plate and spaced apart from the first side wall, a first rotator coupled to the first housing and rotatably connected to the hinge housing, a second rotator coupled to the second housing and rotatably connected to the hinge housing, and a first link connected to the first rotator. At least a portion of the first link is located to be movable between the first side wall and the second side wall.

According to an embodiment of the disclosure, a hinge assembly may include a hinge housing including a base plate, a first side wall protruding from the base plate, and a second side wall protruding from the base plate and spaced apart from the first side wall, a first rotator rotatably connected to the hinge housing, a second rotator rotatably connected to the hinge housing and spaced apart from the first rotator, and a first link connected to the first rotator. At least a portion of the first link is located between the first side wall and the second side wall.

### [Brief Description of Drawings]

FIG. 1 is a block diagram of an electronic device according to various embodiments in a network environment.
FIG. 2 is a perspective view illustrating an electronic device according to an embodiment of the disclosure in an unfolded state.
FIG. 3 is a perspective view illustrating the electronic device according to an embodiment of the disclosure in the unfolded state.
FIG. 4 is a perspective view illustrating the electronic device according to an embodiment of the disclosure in a folded state.
FIG. 5 is a side view of the electronic device according to an embodiment of the disclosure in the folded state.
FIG. 6 is an exploded perspective view of a portion of the electronic device according to an embodiment of the disclosure.
FIG. 7 is an exploded perspective view of a portion of the electronic device according to an embodiment of the disclosure.
FIG. 8A is an exploded perspective view of a portion of the electronic device according to an embodiment of the disclosure.
FIG. 8B is a view illustrating a portion of an electronic device according to an embodiment of the disclosure.
FIG. 9A is a view illustrating a portion of the electronic device according to an embodiment of the disclosure.
FIG. 9B is a view illustrating a portion of the electronic device according to an embodiment of the disclosure.
FIG. 10 is an exploded view of a portion of the electronic device according to an embodiment of the disclosure.
FIG. 11 is a view illustrating a portion of the electronic device according to an embodiment of the disclosure.
FIG. 12 is a view illustrating a portion of the electronic device according to an embodiment of the disclosure.
FIG. 13 is a cross-sectional view of a portion of the electronic device according to an embodiment of the disclosure.
FIG. 14A is a view illustrating a portion of the electronic device according to an embodiment of the disclosure.
FIG. 14B is a view illustrating a portion of the electronic device according to an embodiment of the disclosure.
FIG. 15 is a view illustrating a portion of the electronic device according to an embodiment of the disclosure.
FIG. 16A is a view illustrating a portion of the electronic device according to an embodiment of the disclosure.
FIG. 16B is a view illustrating a portion of the electronic device according to an embodiment of the disclosure.
FIG. 16C is a view illustrating a portion of the electronic device according to an embodiment of the disclosure.
FIG. 17 is a view illustrating a portion of the electronic device according to an embodiment of the disclosure.
FIG. 18 is a view illustrating a portion of the electronic device according to an embodiment of the disclosure.
FIG. 19 is a view illustrating a portion of an electronic device according to an embodiment of the disclosure.
FIG 20A is a cross-sectional view illustrating a portion of the electronic device according to an embodiment of the disclosure.
FIG 20B is a cross-sectional view of a portion of the electronic device according to an embodiment of the disclosure.
FIG 20C is a cross-sectional view of a portion of the electronic device according to an embodiment of the disclosure.
FIG. 21A is a cross-sectional view of a portion of the electronic device according to an embodiment of the disclosure.
FIG 21B is a cross-sectional view of a portion of the electronic device according to an embodiment of the disclosure.
FIG 21C is a cross-sectional view of a portion of the electronic device according to an embodiment of the disclosure.
FIG. 22A is a cross-sectional view of a portion of the electronic device according to an embodiment of the disclosure.
FIG 22B is a cross-sectional view of a portion of the electronic device according to an embodiment of the disclosure.
FIG 22C is a cross-sectional view of a portion of the electronic device according to an embodiment of the disclosure.
FIG. 23A is a cross-sectional view of a portion of the electronic device according to an embodiment of the disclosure.
FIG 23B is a cross-sectional view of a portion of the electronic device according to an embodiment of the disclosure.
FIG 23C is a cross-sectional view of a portion of the electronic device according to an embodiment of the disclosure.
FIG. 24 is a view illustrating a portion of an electronic device according to an embodiment of the disclosure.
FIG. 25 is a view illustrating a portion of an electronic device according to an embodiment of the disclosure.
FIG. 26 is a cross-sectional view of a portion of the electronic device according to an embodiment of the disclosure.
FIG. 27A is a view illustrating a portion of the electronic device according to an embodiment of the disclosure.
FIG. 27B is a cross-sectional view of a portion of the electronic device according to an embodiment of the disclosure.
FIG. 27C is a cross-sectional view of a portion of the electronic device according to an embodiment of the disclosure.
FIG. 28 is a view illustrating a portion of the electronic device according to an embodiment of the disclosure.
FIG. 29 is a view illustrating a portion of an electronic device according to an embodiment of the disclosure.
FIG. 30 is a view illustrating a portion of the electronic device according to an embodiment of the disclosure.
FIG. 31 is a view illustrating a portion of the electronic device according to an embodiment of the disclosure.
FIG. 32 is an exploded view of a portion of the electronic device according to an embodiment of the disclosure.
FIG. 33 is a view illustrating a portion of the electronic device according to an embodiment of the disclosure.
FIG. 34 is an exploded view of a portion of the electronic device according to an embodiment of the disclosure.
FIG. 35 is a cross-sectional view of a portion of the electronic device according to an embodiment of the disclosure.
FIG. 36 is a view illustrating a portion of the electronic device according to an embodiment of the disclosure.
FIG. 37 is a view illustrating a portion of the electronic device according to an embodiment of the disclosure.
FIG. 38 is a view illustrating a portion of the electronic device according to an embodiment of the disclosure.
FIG. 39 is a view illustrating a portion of an electronic device according to an embodiment of the disclosure.
FIG. 40 is a cross-sectional view of a portion of the electronic device according to an embodiment of the disclosure.
FIG. 41 is a view illustrating a portion of the electronic device according to an embodiment of the disclosure.
FIG. 42 is a side view of an electronic device according to an embodiment of the disclosure.
FIG. 43 is a cross-sectional view of a portion of the electronic device according to an embodiment of the disclosure.
FIG. 44 is a view illustrating a portion of the electronic device according to an embodiment of the disclosure.
FIG. 45 is a cross-sectional view of a portion of the electronic device according to an embodiment of the disclosure.

### [Mode for Carrying out the Invention]

The following description with reference to the appended drawings may provide an understanding of various exemplary implementations of the disclosure, including the claims and their equivalents. An exemplary embodiment disclosed in the following description includes various specific details to help understanding, but is considered to be one of various exemplary embodiments. Accordingly, it will be understood by a person ordinarily skilled in the art that various implementations described herein may be variously changed and modified without departing from the scope and spirit of the disclosure. In addition, descriptions of well-known functions and configurations may be omitted for clarity and brevity.

The terms and words used in the following description and claims are not limited to a bibliographical meaning, but may be used to describe an embodiment of the disclosure clearly and consistently. Accordingly, it will be apparent to those skilled in the art that the following description of various implementations of the disclosure is provided for explanatory purposes and not intended to limit the scope of the disclosure and equivalents thereof.

Unless the context clearly indicates otherwise, the singular forms of "a," "an," and "the" should be understood to include the plural meaning. Accordingly, for example, the term "a component surface" may be understood to include one or more surfaces of the component.

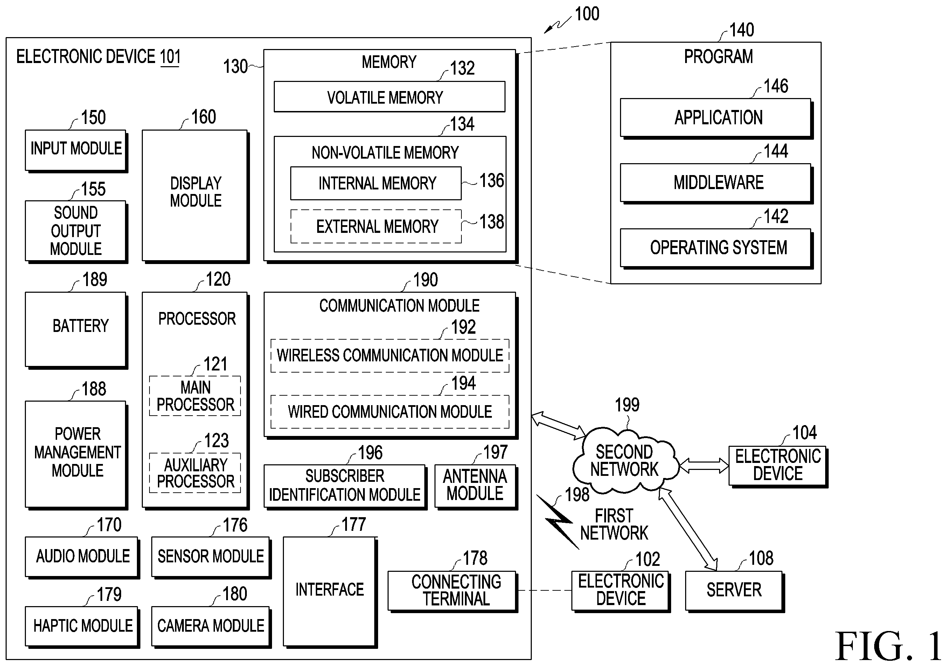

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

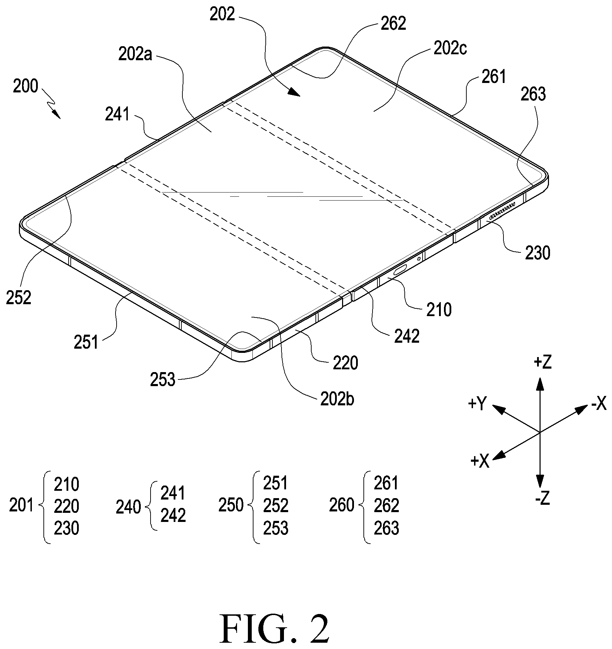

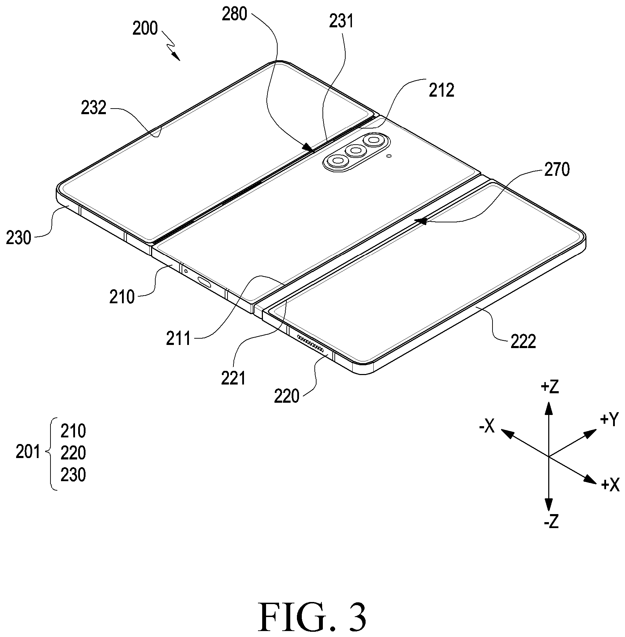

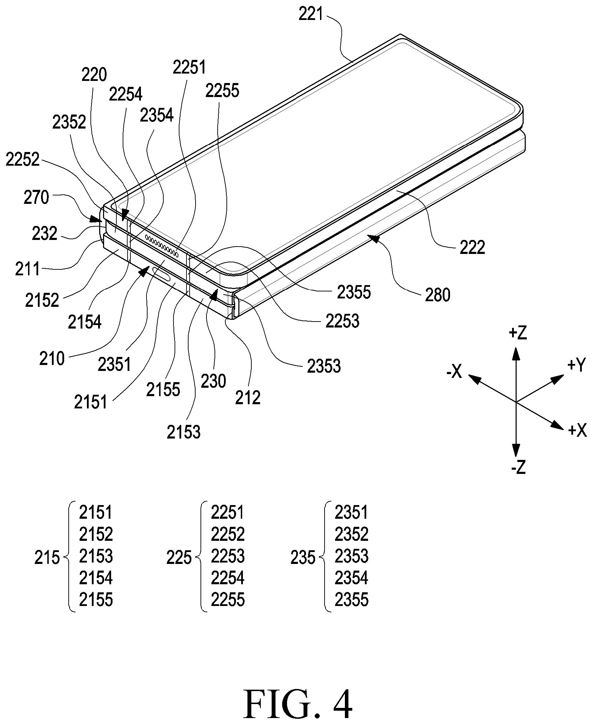

FIG. 2 is a perspective view illustrating an electronic device 200 according to an embodiment of the disclosure in an unfolded state. FIG. 3 is a perspective view illustrating the electronic device 200 according to an embodiment of the disclosure in the unfolded state. FIG. 2 may obliquely illustrate one side (e.g., a front side) of the electronic device 200, and FIG. 3 may obliquely illustrate the other side (e.g., a rear side) of the electronic device 200. The components to be described with reference to FIGS. 2 and 3 may be the same as some or all of the components described with reference to FIG. 1. The components to be described with reference to FIGS. 2 and 3 may be partially or entirely the same as the components to be described with reference to FIGS. 4 to 18. As illustrated in FIGS. 2 and 3, a state in which the electronic device 200 is unfolded may be defined as a "first state."

According to an embodiment, the electronic device 200 may include a housing 201. The electronic device 200 may include a display 202. The housing 201 may form a space in which the display 202 is disposed. The display 202 may be a flexible display . At least a portion of the display 202 may be foldable or unfoldable.

According to an embodiment, the housing 201 may include a first housing 210. The housing 201 may include a second housing 220. The housing 201 may include a third housing 230. The first housing 210 may be disposed between the second housing 220 and the third housing 230. The second housing 220 may be rotatably coupled to the first housing 210. The third housing 230 may be rotatably coupled to the first housing 210. The display 202 may include a first display region 202a corresponding to the first housing 210, a second display region 202b corresponding to the second housing 220, and a third display region 202c corresponding to the third housing 230.

According to an embodiment, the electronic device 200 may include supports 240, 250, and 260. The supports 240, 250, and 260 may be disposed between the housing 201 and the display 202. The supports 240, 250, and 260 may be coupled to the housing 201 and may support the display 202. The supports 240, 250, and 260 may be disposed to surround edges of the display 202. The supports 240, 250, and 260 may extend along the perimeter of the housing 201. The supports 240, 250, and 260 may include a first support 240 disposed on the first housing 210, a second support 250 disposed on the second housing 220, and a third support 260 disposed on the third housing 230. The supports 240, 250, and 260 may be referred to as "bodies." The supports 240, 250, and 260 may be referred to as "frames." The supports 240, 250, and 260 may be referred to as "sealing members." The supports 240, 250, and 260 may be referred to as "peripheral parts." The supports 240, 250, and 260 may be referred to as "circumferential parts." The supports 240, 250, and 260 may be referred to as "peripheral structures." The supports 240, 250, and 260 may be referred to as "circumferential structures." The supports 240, 250, and 260 may be disposed between the housings 210, 220, and 230 and the display 202. The supports 240, 250, and 260 may reduce friction between the housings 210, 220, and 230 and the display 202. The supports 240, 250, and 260 may be referred to as "buffer members."

According to an embodiment, the supports 240, 250, and 260 may include the first support 240. The first support 240 may be disposed between the first housing 210 and the display 202. The first support 240 may be disposed along the edge of the first housing 210. The first support 240 may include a (1-1)^{th} support 241 and a (1-2)^{th} support 242. At least a portion of the display 202 may be disposed between the (1-1)^{th} support 241 and the (1-2)^{th} support 242. The (1-1)^{th} support 241 may be disposed at one end portion of the first housing 210, and the (1-2)^{th} support 242 may be disposed at the other end portion of the first housing 210. Each of the first, second, and third supports 240, 250, and 260 may be referred to as a "support." The supports 240, 250, and 260 may be referred to as "decorations," "finishing members," or "non-conductive members."

According to an embodiment, the supports 240, 250, and 260 may include a second support 250. The second support 250 may be disposed between the second housing 220 and the display 202. The second support 250 may be disposed along an edge of the second housing 220. The second support 250 may include a (2-1)^{th} support 251, a (2-2)^{th} support 252, and a (2-3)^{th} support 253. At least a portion of the display 202 may be disposed between the (2-2)^{th} support 252 and the (2-3)^{th} support 253. The (2-1)^{th} support 251 may connect the (2-2)^{th} support 252 and the (2-3)^{th} support 253. The (2-1)^{th} support 251 may extend along an edge 222 (e.g., the edge 222 of FIG. 3) of the second housing 220. The (2-1)^{th} support 251 may be disposed between the edge 222 of the second housing 220 and the display 202. The (2-1)^{th} support 251 may be referred to as a "support frame" or a "first support frame." Each of the (2-2)^{th} support 252 and the (2-3)^{th} support 253 may be referred to as a "second support frame."

According to an embodiment, the supports 240, 250, and 260 may include a third support 260. The third support 260 may be disposed between the third housing 230 and the display 202. The third support 260 may be disposed along an edge of the third housing 230. The third support 260 may include a (3-1)^{th} support 261, a (3-2)^{th} support 262, and a (3-3)^{th} support 263. At least a portion of the display 202 may be disposed between the (3-2)^{th} support 262 and the (3-3)^{th} support 263. The (3-1)^{th} support 261 may connect the (3-2)^{th} support 262 and the (3-3)^{th} support 263. The (3-1)^{th} support 261 may extend along an edge (e.g., the edge 232 of FIG. 3) of the third housing 230. The (3-1)^{th} support 261 may be disposed between the edge 232 of the third housing 230 and the display 202. The (3-1)^{th} support 261 may be referred to as a "support frame" or a "first support frame." Each of the (3-2)^{th} support 262 and the (3-3)^{th} support 263 may be referred to as a "second support frame."

According to an embodiment, the first housing 210 may include a (1-1)^{th} side portion 211 and a (1-2)^{th} side portion 212. Each of the (1-1)^{th} side portion 211 and the (1-2)^{th} side portion 212 may form opposite sides of the first housing 210. The second housing 220 may be coupled to the (1-1)^{th} side portion 211. The third housing 230 may be coupled to the (1-2)^{th} side portion 212. The (1-1)^{th} side portion 211 may be referred to as a "first coupling portion." The (1-2)^{th} side portion 212 may be referred to as a "second coupling portion." The (1-1)^{th} side portion 211 may be referred to as a "first portion." The (1-2)^{th} side portion 212 may be referred to as a "second portion."

According to an embodiment, the second housing 220 may include a (2-1)^{th} side portion 221 and a (2-2)^{th} side portion 222. Each of the (2-1)^{th} side portion 221 and the (2-2)^{th} side portion 222 may define opposite sides of the second housing 220. The (2-1)^{th} side portion 221 may be coupled to the first housing 210. The (2-2)^{th} side portion 222 may define a side surface of the housing 201. The (2-2)^{th} side portion 222 may be referred to as an "edge." The (2-1)^{th} side portion 221 may be referred to as a "third side portion." The (2-2)^{th} side portion 222 may be referred to as a "fourth side portion."

According to an embodiment, the third housing 230 may include a (3-1)^{th} side portion 231 and a (3-2)^{th} side portion 232. Each of the (3-1)^{th} side portion 231 and the (3-2)^{th} side portion 232 may define opposite sides of the third housing 230. The (3-1)^{th} side portion 231 may be coupled to the first housing 210. The (3-2)^{th} side portion 232 may define a side surface of the housing 201. The (3-2)^{th} side portion 232 may be referred to as an "edge." The (3-1)^{th} side portion 231 may be referred to as a "fifth side portion." The (3-2)^{th} side portion 232 may be referred to as a "sixth side portion."

According to an embodiment, the electronic device 200 may include a first hinge 270 and a second hinge 280. The first hinge 270 may be disposed between the first housing 210 and the second housing 220. The first hinge 270 may be disposed between the (1-1)^{th} side portion 211 and the (2-1)^{th} side portion 221. The first hinge 270 may rotatably connect the first housing 210 and the second housing 220. The second hinge 280 may be disposed between the first housing 210 and the third housing 230. The second hinge 280 may be disposed between the (1-2)^{th} side portion 212 and the (3-1)^{th} side portion 231. The second hinge 280 may rotatably connect the first housing 210 and the third housing 230.

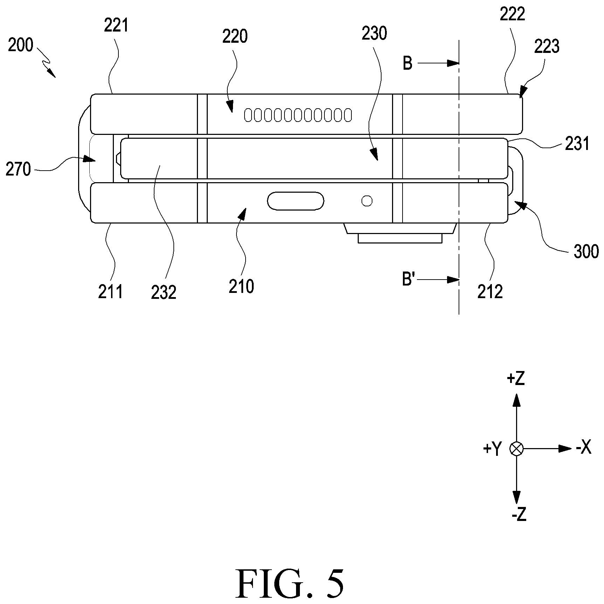

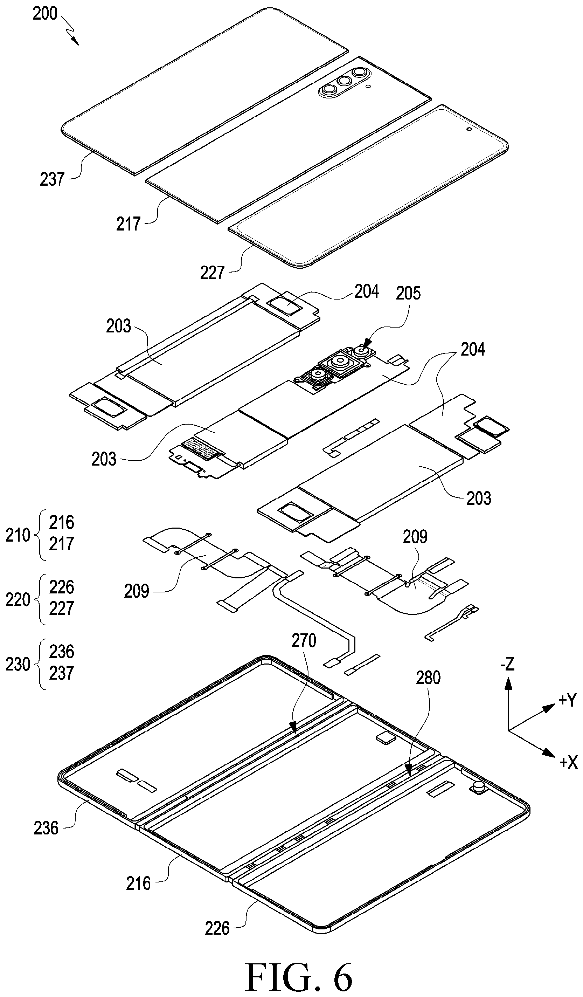

FIG. 4 is a perspective view illustrating the electronic device 200 according to an embodiment of the disclosure in a folded state. FIG. 5 is a side view illustrating the electronic device 200 of FIG. 4 viewed from one direction (e.g., the -Y direction) toward the other direction (e.g., the +Y direction). The components to be described with reference to FIGS. 4 and 5 may be the same as some or all of the components described with reference to FIGS. 1 to 3. The components described with reference to FIGS. 4 and 5 may be partially or entirely the same as the components described with reference to FIGS. 6 to 45.

According to an embodiment, the second housing 220 may be rotated relative to the first housing 210. The first hinge 270 may provide a rotation center for the second housing 220. The first hinge 270 may connect the (1-1)^{th} side portion 211 and the (2-1)^{th} side portion 221. The third housing 230 may be rotated relative to the first housing 210. The second hinge 280 may provide a rotation center for the third housing 230. The second hinge 280 may connect the (1-2)^{th} side portion 212 and the (3-1)^{th} side portion 231.

According to an embodiment, in a state in which the electronic device 200 is folded, each of the first, second, and third housings 210, 220, and 230 may be arranged in one direction (e.g., the +Y direction). For example, the third housing 230 may be disposed on an upper side of the first housing 210, and the second housing 220 may be disposed on an upper side of the third housing 230. For example, the third housing 230 may be disposed between the first housing 210 and the second housing 220.

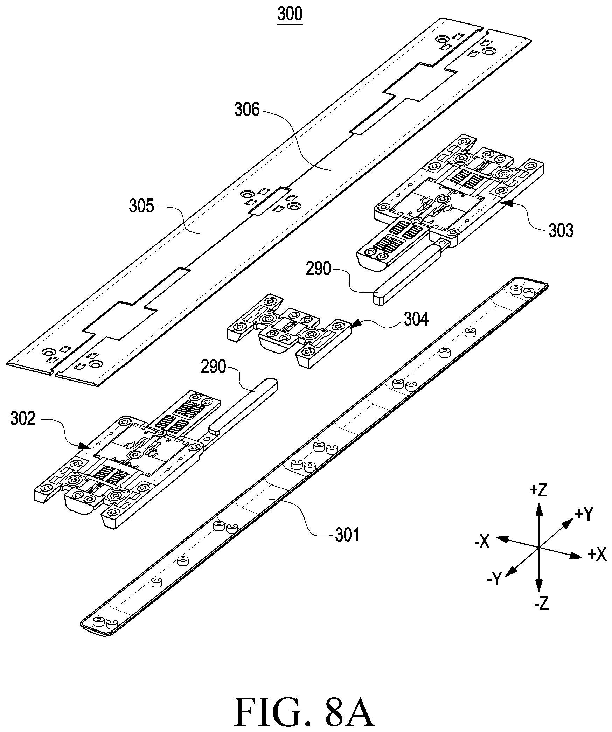

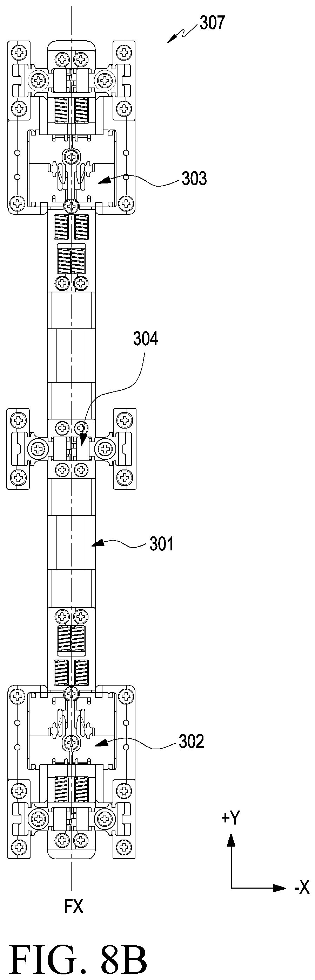

According to an embodiment, the electronic device 200 may include an antenna 223. The antenna 223 may be formed at the edge 222 of the second housing 220. The antenna 223 may be integral with the second housing 220 and may be a portion of the edge 222. The antenna 223 may be manufactured separately from the second housing 220 and may be coupled to the edge 222 of the second housing 220. The antenna 223 may be referred to as a "first conductive portion." The antenna 223 may include a metallic material. According to an embodiment, the edge 222 of the second housing 220 may be a region of the second housing 220 overlapping a portion in which a screen of the flexible display 202 is invisible from outside the housing (e.g., the second housing 220) when the flexible display 202 is viewed in a screen display direction (e.g., the +Z direction). For example, the edge 222 of the second housing 220 may include a bezel portion (e.g., the second support portion 257 of FIG. 8) and the antenna 223 of the second housing 220.

According to an embodiment, in a state in which the electronic device 200 is folded, the antenna 223 may be spaced apart from the second hinge 280. One surface of the antenna 223 may face the second hinge 280. The first hinge 270 may have a width greater than a width of the second hinge 280. For example, based on FIG. 5A, a length by which the first hinge 270 extends in the +Z direction may be greater than a length by which the second hinge 280 extends in the +Z direction.

According to an embodiment, the antenna 223 may include a first antenna portion 2231, a second antenna portion 2232, and a third antenna portion 2233. Each of the first, second, and third antenna portions 2231, 2232, and 2233 may be spaced apart from one another along the edge 222 of the second housing 220. Each of the first, second, and third antenna portions 2231, 2232, and 2233 may include a conductive material. The antenna 223 may include a first segmentation portion 2234 and a second segmentation portion 2235. The first segmentation portion 2234 may be disposed between the first antenna portion 2231 and the second antenna portion 2232. The second segmentation portion 2235 may be disposed between the first antenna portion 2231 and the third antenna portion 2233.

According to an embodiment, the electronic device 200 may include a first antenna 215, a second antenna 225, and a third antenna 235. The first antenna 215 may form a portion of the first housing 210. The first antenna 215 may form at least a portion of a surface of the first housing 210. The second antenna 225 may form a portion of the second housing 220. The second antenna 225 may form at least a portion of the surface of the second housing 220. The third antenna 235 may form a portion of the third housing 230. The third antenna 235 may form at least a portion of a surface of the third housing 230.

According to an embodiment, the first antenna 215 may include a (1-1)^{th} antenna portion 2151, a (1-2)^{th} antenna portion 2152, and a (1-3)^{th} antenna portion 2153. The (1-1)^{th} antenna portion 2151 may be disposed between the (1-2)^{th} antenna portion 2152 and the (1-3)^{th} antenna portion 2153. The first antenna 215 may include a (1-1)^{th} segmentation portion 2154 and a (1-2)^{th} segmentation portion 2155. The (1-1)^{th} antenna portion 2151 and the (1-2)^{th} antenna portion 2152 may be spaced apart from each other, and the (1-1)^{th} segmentation portion 2154 may be disposed between the (1-1)^{th} antenna portion 2151 and the (1-2)^{th} antenna portion 2152. The (1-1)^{th} antenna portion 2151 and the (1-3)^{th} antenna portion 2153 may be spaced apart from each other, and the (1-2)^{th} segmentation portion 2155 may be disposed between the (1-1)^{th} antenna portion 2151 and the (1-3)^{th} antenna portion 2153.

According to an embodiment, the second antenna 225 may include a (2-1)^{th} antenna portion 2251, a (2-2)^{th} antenna portion 2252, and a (2-3)^{th} antenna portion 2253. The (2-1)^{th} antenna portion 2251 may be disposed between the (2-2)^{th} antenna portion 2252 and the (2-3)^{th} antenna portion 2253. The second antenna 225 may include a (2-1)^{th} segmentation portion 2254 and a (2-2)^{th} segmentation portion 2255. The (2-1)^{th} antenna portion 2251 and the (2-2)^{th} antenna portion 2252 may be spaced apart from each other, and the (2-1)^{th} segmentation portion 2254 may be disposed between the (2-1)^{th} antenna portion 2251 and the (2-2)^{th} antenna portion 2252. The (2-1)^{th} antenna portion 2251 and the (2-3)^{th} antenna portion 2253 may be spaced apart from each other, and the (2-2)^{th} segmentation portion 2255 may be disposed between the (2-1)^{th} antenna portion 2251 and the (2-3)^{th} antenna portion 2253.

According to an embodiment, the third antenna 235 may include a (3-1)^{th} antenna portion 2351, a (3-2)^{th} antenna portion 2352, and a (3-3)^{th} antenna portion 2353. The (3-1)^{th} antenna portion 2351 may be disposed between the (3-2)^{th} antenna portion 2352 and the (3-3)^{th} antenna portion 2353. The third antenna 235 may include a (3-1)^{th} segmentation portion 2354 and a (3-2)^{th} segmentation portion 2355. The (3-1)^{th} antenna portion 2351 and the (3-2)^{th} antenna portion 2352 may be spaced apart from each other, and the (3-1)^{th} segmentation portion 2354 may be disposed between the (3-1)^{th} antenna portion 2351 and the (3-2)^{th} antenna portion 2352. The (3-1)^{th} antenna portion 2351 and the (3-3)^{th} antenna portion 2353 may be spaced apart from each other, and the (3-2)^{th} segmentation portion 2355 may be disposed between the (3-1)^{th} antenna portion 2351 and the (3-3)^{th} antenna portion 2353.

According to an embodiment, in the folded state of the electronic device 200, the first housing 210, the second housing 220, and the third housing 230 may be aligned with each other. For example, in the folded state of the electronic device 200, the first housing 210, the third housing 230, and the second housing 220 may be aligned in that order in one direction (e.g., the +Z direction). In the folded state of the electronic device 200, the first antenna 215, the second antenna 225, and the third antenna 235 may be aligned with each other. For example, in the folded state of the electronic device 200, the first antenna 215, the third antenna 235, and the second antenna 225 may be aligned in that order in one direction (e.g., the +Z direction). In the folded state of the electronic device 200, the first antenna 215, the second antenna 225, and the third antenna 235 may be aligned with each other in a direction in which the housings 210, 220, and 230 are stacked (e.g., the +Z direction). For example, in the folded state of the electronic device 200, the (1-1)^{th} antenna portion 2151, the (2-1)^{th} antenna portion 2251, and the (3-1)^{th} antenna portion 2351 may be aligned in a first direction (e.g., the +Z direction). For example, in the folded state of the electronic device 200, the (1-2)^{th} antenna portion 2152, the (2-2)^{th} antenna portion 2252, and the (3-2)^{th} antenna portion 2352 may be aligned in the first direction (e.g., the +Z direction). For example, in the folded state of the electronic device 200, the (1-3)^{th} antenna portion 2153, the (2-3)^{th} antenna portion 2253, and the (3-3)^{th} antenna portion 2353 may be aligned in the first direction (e.g., the +Z direction). For example, in the folded state of the electronic device 200, the (1-1)^{th} segmentation portion 2154, the (2-1)^{th} segmentation portion 2254, and the (3-1)^{th} segmentation portion 2354 may be aligned in the first direction (e.g., the +Z direction). For example, in the folded state of the electronic device 200, the (1-2)^{th} segmentation portion 2155, the (2-2)^{th} segmentation portion 2255, and the (3-2)^{th} segmentation portion 2355 may be aligned in the first direction (e.g., the +Z direction).

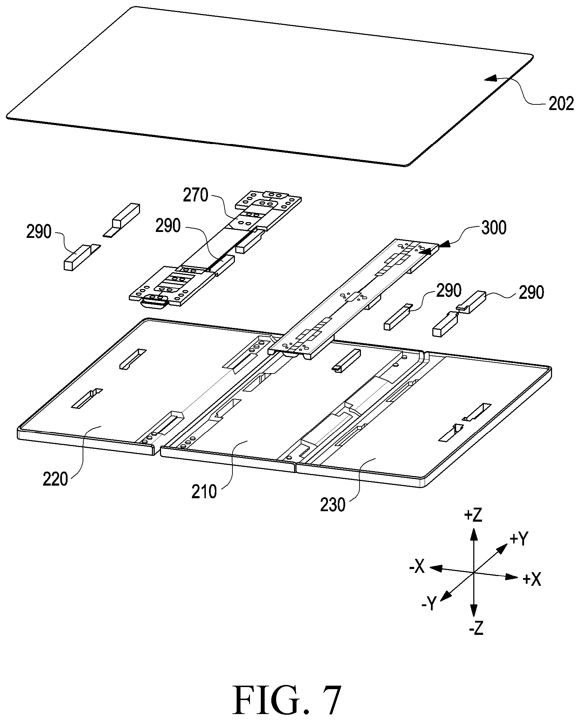

FIG. 6 illustrates a portion of the electronic device 200 according to an embodiment of the disclosure in an exploded state. FIG. 6 illustrates a state in which the display (e.g., the display 202 of FIG. 2) is not illustrated. The components to be described with reference to FIG. 6 may be partially or entirely the same as the components described with reference to FIGS. 1 to 5. The components to be described with reference to FIG. 6 may be partially or entirely the same as the components to be described with reference to FIGS. 7 to 45.

According to an embodiment, the first housing 210 may include a first housing body 216. The first housing 210 may include a first cover 217. The first housing body 216 and the first cover 217 may be coupled to each other. At least a portion of the display (e.g., the display 202 of FIG. 2) may be seated on the first housing body 216. At least a portion of a second display (e.g., the second display 206 of FIG. 8) may be disposed between the first housing body 216 and the first cover 217.

According to an embodiment, the second housing 220 may include a second housing body 226. The second housing 220 may include a second cover 227. The second housing body 226 and the second cover 227 may be coupled to each other. At least a portion of the display (e.g., the display 202 of FIG. 2) may be seated on the second housing body 226. At least a portion of the second display (e.g., the second display 206 of FIG. 8) may be disposed between the second housing body 226 and the second cover 227. The antenna (e.g., the antenna 223 of FIG. 5) may form a portion of the second housing body 226.

According to an embodiment, the third housing 230 may include a third housing body 236. The third housing 230 may include a third cover 237. The third housing body 236 and the third cover 237 may be coupled to each other. At least a portion of the display (e.g., the display 202 of FIG. 2) may be seated on the third housing body 236. At least a portion of the second display (e.g., the second display 206 of FIG. 8) may be disposed between the third housing body 236 and the third cover 237.

According to an embodiment, the first hinge 270 may rotatably connect the first housing body 216 and the second housing body 226. The second hinge 280 may rotatably connect the first housing body 216 and the third housing body 236.

According to an embodiment, the electronic device 200 may include a battery 203. The battery 203 may supply power to electrical components (e.g., the display 202, the second display 206, and the circuit board 204) of the electronic device 200. The battery 203 may be disposed between the housing bodies 216, 226, and 236 and the covers 217, 227, and 237. The electronic device 200 may include a circuit board 204. The circuit board 204 may be electrically connected to electrical components (e.g., the display 202, the second display 206, the antenna circuit 2236, and the battery 203) of the electronic device 200. The circuit board 204 may be disposed between the housing bodies 216, 226, and 236 and the covers 217, 227, and 237. The electronic device 200 may include a camera assembly 205. The camera assembly 205 may be disposed between the housing bodies 216, 226, and 236 and the covers 217, 227, and 237. The electronic device 200 may include a flexible circuit board 209. The flexible circuit board 209 may be connected to the circuit board 204.

According to an embodiment, the electronic device 200 may include a second conductive portion 233. The second conductive portion 233 may be a portion of the third housing 230. The second conductive portion 233 may be disposed between the first housing 210 and the second housing 220 in the folded state of the electronic device 200. The second conductive portion 233 may face the first hinge 270 in the folded state of the electronic device 200.

FIG. 7 is a view illustrating the electronic device 200 in a partially disassembled state. The components to be described with reference to FIG. 7 may be partially or entirely the same as the components described with reference to FIGS. 1 to 6. The components to be described with reference to FIG. 7 may be partially or entirely the same as the components to be described with reference to FIGS. 8A to 45.

According to an embodiment, the electronic device 200 may include a display 202 and housings 210, 220, and 230. The display 202 may be seated on the housings 210, 220, and 230. The display 202 may be disposed on the housings 210, 220, and 230 such that at least a portion thereof is deformable. The housings 210, 220, and 230 may include the first housing 210, the second housing 220, and the third housing 230. The first housing 210 and the second housing 220 may be rotatably coupled. The first housing 210 and the third housing 230 may be rotatably coupled. The second housing 220 may be referred to as a "third housing," and the third housing 230 may be referred to as a "second housing."

According to an embodiment, the electronic device 200 may include a first hinge 270 and a second hinge 300. The first hinge 270 may rotatably connect the first housing 210 and the second housing 220. The second hinge 300 may rotatably connect the first housing 210 and the third housing 230. Referring to FIG. 5, in a state in which the electronic device 200 is folded, the third housing 230 may be disposed between the first housing 210 and the second housing 220. The first hinge 270 may have a greater width than the second hinge 300. Referring to FIG. 5, a width of the first hinge 270 in one direction (e.g., the +Z direction) may be greater than a width of the second hinge 300 in one direction (e.g., the +Z direction). The first hinge 270 may be referred to as a "wide hinge." The second hinge 300 may be referred to as a "narrow hinge." Each of the first hinge 270 and the second hinge 300 may be referred to as a "hinge." Each of the first hinge 270 and the second hinge 300 may be referred to as a "hinge assembly."

According to an embodiment, the electronic device 200 may include a magnet 290. The magnet 290 may be fixed to the housings 210, 220, and 230 or to the hinges 270 and 300.

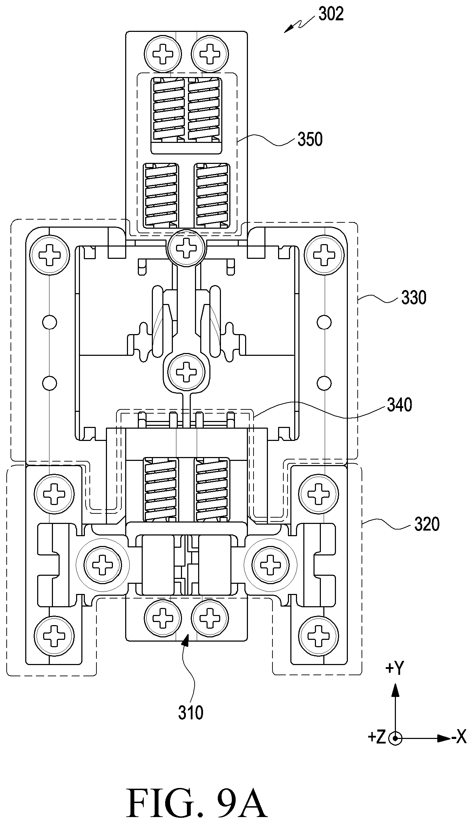

FIG. 8A is a view illustrating the hinge assembly 300 in a disassembled state. FIG. 8B is a view illustrating a portion of the hinge assembly 300 in an assembled state. The components to be described with reference to FIGS. 8A and 8B may be partially or entirely the same as the components described with reference to FIGS. 1 to 7. Components described with reference to FIGS. 8A and 8B may be partially or entirely the same as the components described with reference to FIGS. 9A to 45.

According to an embodiment, the hinge assembly 300 may include a hinge housing 301. The hinge housing 301 may extend in one direction (e.g., the +Y direction).

According to an embodiment, the hinge assembly 300 may include hinges 302, 303, and 304. The hinges 302, 303, and 304 may be seated on the hinge housing 301. At least a portion of the hinges 302, 303, and 304 may be accommodated in the hinge housing 301. The hinges 302, 303, and 304 may include multiple hinge structures 302, 303, and 304. The hinges 302, 303, and 304 may include a first hinge 302, a second hinge 303, and a third hinge 304. The first hinge 302, the second hinge 303, and the third hinge 304 may be spaced apart from each other in a longitudinal direction of the hinge housing 301. The first hinge 302 and the second hinge 303 may be identical to each other. For example, the first hinge 302 and the second hinge 303 may include identical components, an assembly relationship of which may be identical. The third hinge 304 may be identical to a portion of the first hinge 302. For example, the third hinge 304 may include some components of the first hinge 302. The third hinge 304 may be disposed between the first hinge 302 and the second hinge 303.

According to an embodiment, the hinge assembly 300 may include a first support plate 305 and a second support plate 306. The first support plate 305 may be disposed between the hinges 302, 303, and 304 and the display (e.g., the display 202 of FIG. 7). The first support plate 305 may support the display 202. The second support plate 306 may be disposed between the hinges 302, 303, and 304 and the display (e.g., the display 202 of FIG. 7). The second support plate 306 may support the display 202. The first support plate 305 and the second support plate 306 may be seated on the hinges 302, 303, and 304. The hinges 302, 303, and 304 may rotate the first support plate 305 and the second support plate 306.

According to an embodiment, the hinge assembly 300 may include a hinge structure 307. The hinge structure 307 may include a hinge housing 301, a first hinge 302, a second hinge 303, and a third hinge 304. The hinge structure 307 may be understood as an assembly of the plurality of hinges 302, 303, and 304 and the hinge housing 301. The plurality of hinges 302, 303, and 304 may be rotated about a folding axis FX. The plurality of hinges 302, 303, and 304 may have a structure symmetrical about the folding axis FX. The folding axis FX may extend in a direction in which the hinge housing 301 extends (e.g., the +Y direction).

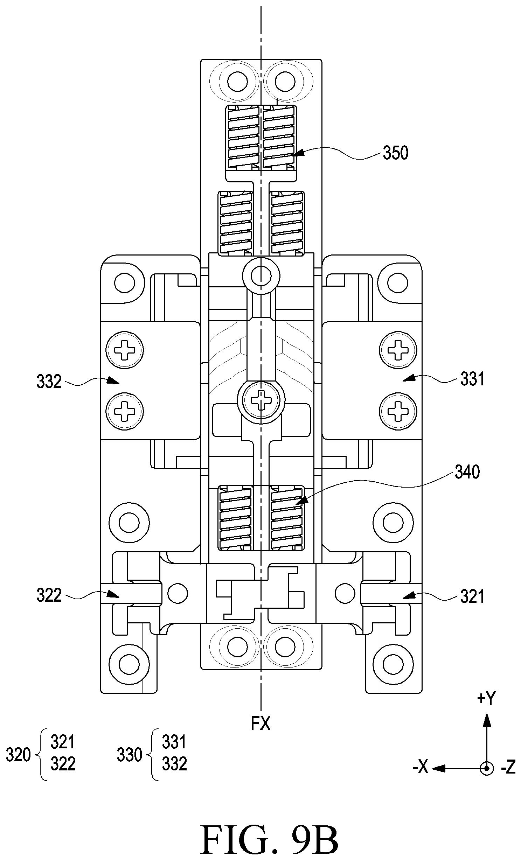

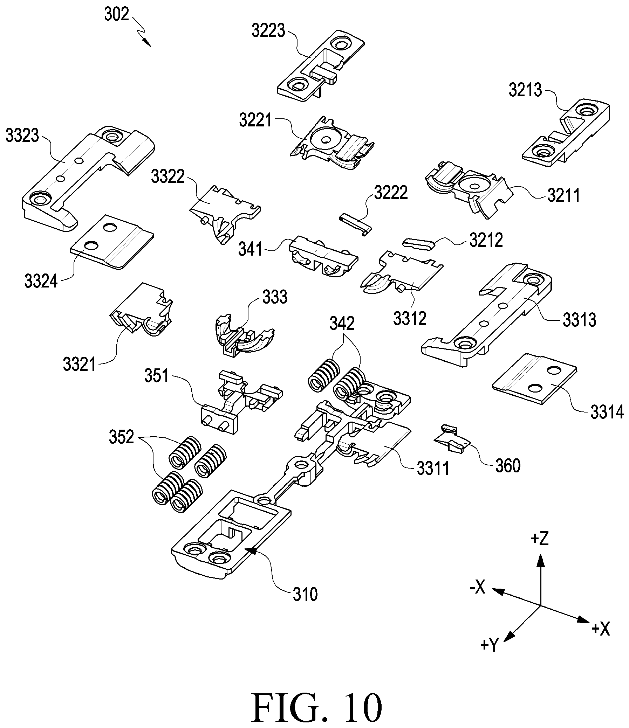

FIG. 9A is an enlarged view of the hinge 302 illustrated in FIG. 8B. FIG. 9B is a view illustrating the hinge 302 illustrated in FIG. 9A, as viewed from an opposite direction (e.g., from the -Z direction toward the +Z direction). The components to be described with reference to FIGS. 9A and 9B may be partially or entirely the same as the components described with reference to FIGS. 1 to 8B. The components to be described with reference to FIGS. 9A and 9B may be partially or entirely the same as the components to be described with reference to FIGS. 10 to 45.

According to an embodiment, the hinge 302 may include a base frame 310. The base frame 310 may be fixed to the hinge housing (e.g., the hinge housing 301 of FIG. 8A). The base frame 310 may provide a space in which other components 320, 330, 340, and 350 are disposed. Components 320, 330, 340, and 350 constituting the hinge 302 may be movably coupled to the base frame 310.

According to an embodiment, the hinge 302 may include a first link assembly 320. The first link assembly 320 may be rotatably coupled to the base frame 310. The hinge 302 may include a second link assembly 330. The second link assembly 330 may be rotatably coupled to the base frame 310. The first link assembly 320 and the second link assembly 330 may be rotated about a folding axis FX. The first link assembly 320 and the second link assembly 330 may be rotated about a rotation axis. The rotation axis may be a shaft having a physical shape or may represent the center of a virtual rotational trajectory. The first link assembly 320 and the second link assembly 330 may be coupled to each other. The first link assembly 320 and the second link assembly 330 may be engaged with each other to move together.

According to an embodiment, the hinge 302 may include a first spring structure 340. The first spring structure 340 may be movably disposed on the base frame 310. The first spring structure 340 may be connected to the second link assembly 330. The first spring structure 340 may be moved by the rotation of the second link assembly 330. The first spring structure 340 may be in contact with at least a portion of the second link assembly 330.

According to an embodiment, the hinge 302 may include a second spring structure 350. The second spring structure 350 may be movably disposed on the base frame 310. The second spring structure 350 may be connected to the second link assembly 330. The second spring structure 350 may be moved by the rotation of the second link assembly 330. The second spring structure 350 may be in contact with at least a portion of the second link assembly 330. The second link assembly 330 may be disposed between the first spring structure 340 and the second spring structure 350.

According to an embodiment, the first link assembly 320 may include a first rotator 321. The first link assembly 320 may include a second rotator 322. The first rotator 321 and the second rotator 322 may be rotatably coupled to the base frame 310. The first rotator 321 and the second rotator 322 may be rotated about the folding axis FX. The first rotator 321 and the second rotator 322 may be rotated about a rotation axis. The rotation axis may be a shaft having a physical shape or may represent the center of a virtual rotational trajectory. The first rotator 321 and the second rotator 322 may be symmetrical with each other about the folding axis FX.

According to an embodiment, the second link assembly 330 may include a first hinge arm 331. The second link assembly 330 may include a second hinge arm 332. The first hinge arm 331 and the second hinge arm 332 may be rotatably coupled to the base frame 310. The first hinge arm 331 and the second hinge arm 332 may be rotated about the folding axis FX. The first hinge arm 331 and the second hinge arm 332 may be rotated about a rotation axis. The rotation axis may be a shaft having a physical shape or may represent the center of a virtual rotational trajectory. The first hinge arm 331 and the second hinge arm 332 may be symmetrical with each other about the folding axis FX.

According to an embodiment, the first rotator 321 may be coupled to the first hinge arm 331. The first rotator 321 and the second hinge arm 332 may be interlocked with each other to move together. The second rotator 322 may be coupled to the second hinge arm 332. The second rotator 322 and the second hinge arm 332 may be interlocked with each other to move together.

According to an embodiment, the first rotator 321 and the first hinge arm 331 may rotate the first housing (e.g., the first housing 210 of FIG. 7). The first rotator 321 and the first hinge arm 331 may provide rotational power to the first housing 210. Each of the first rotator 321 and the first hinge arm 331 may be coupled to the first housing 210. The second rotator 322 and the second hinge arm 332 may rotate the second housing (e.g., the second housing 230 of FIG. 7). The second rotator 322 and the second hinge arm 332 may provide rotational power to the second housing 230. Each of the second rotator 322 and the second hinge arm 332 may be coupled to the second housing 230.

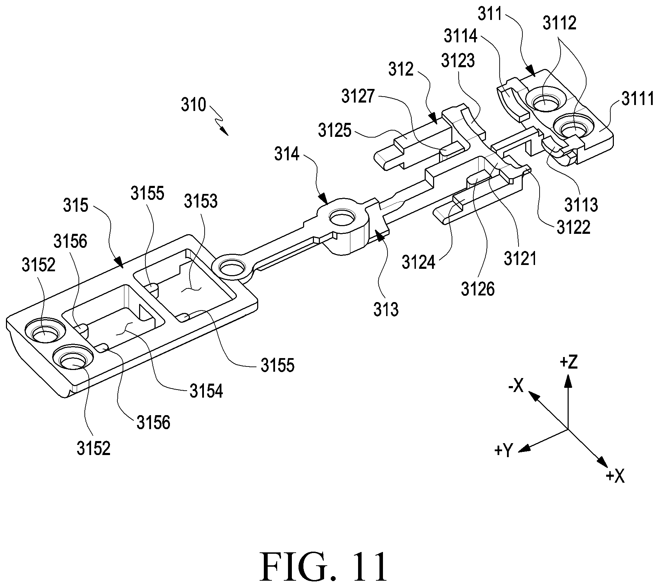

FIG. 10 is an exploded view of the hinge 302. The components to be described with reference to FIG. 10 may be partially or entirely the same as the components described with reference to FIGS. 1 to 9B. The components to be described with reference to FIG. 10 may be partially or entirely the same as the components to be described with reference to FIGS. 11 to 45.

According to an embodiment, the hinge 302 may include a first rotator body 3211. The hinge 302 may include a first rotator wing 3213. The hinge 302 may include a first link 3212. The first rotator 321 (e.g., the first rotator 321 of FIG. 9B) may include the first rotator body 3211 and the first rotator wing 3213. The first rotator body 3211 and the first rotator wing 3213 may be coupled to each other to be relatively rotatable. The first link 3212 may be movably coupled to the first rotator body 3211. The first link 3212 may be rotatably coupled to the first rotator body 3211, slidably coupled to the first rotator body 3211, or coupled to the first rotator body 3211 through gear engagement.

According to an embodiment, the hinge 302 may include a second rotator body 3221. The hinge 302 may include a second rotator wing 3223. The hinge 302 may include a second link 3222. The second rotator (e.g., the second rotator 322 of FIG. 9B) may include the second rotator body 3221 and the second rotator wing 3223. The second rotator body 3221 and the second rotator wing 3223 may be coupled to each other to be relatively rotatable. The second link 3222 may be movably coupled to the second rotator body 3221. The second link 3222 may be rotatably coupled to the second rotator body 3221, may be slidably coupled thereto, or may be coupled thereto through gear engagement.

According to an embodiment, the hinge 302 may include a (1-1)^{th} hinge arm body 3311. The hinge 302 may include a (1-2)^{th} hinge arm body 3312. The hinge 302 may include a first hinge arm wing 3313. The hinge 302 may include a first hinge arm holder 3314. The first hinge arm (e.g., the first hinge arm 331 illustrated in FIG. 9B) may include the (1-1)^{th} hinge arm body 3311, the (1-2)^{th} hinge arm body 3312, the first hinge arm wing 3313, and the first hinge arm holder 3314. The (1-1)^{th} hinge arm body 3311 and the (1-2)^{th} hinge arm body 3312 may be coupled to each other.\ The (1-1)^{th} hinge arm body 3311 and the (1-2)^{th} hinge arm body 3312 may be interlocked with each other to move together. The first hinge arm wing 3313 may be coupled to the first hinge arm bodies 3311 and 3312 to be relatively rotatable. The first hinge arm bodies 3311 and 3312 may include the (1-1)^{th} hinge arm body 3311 and the (1-2)^{th} hinge arm body 3312. The first hinge arm holder 3314 may be coupled to the first hinge arm wing 3313. The first hinge arm holder 3314 may move together with the first hinge arm wing 3313.

According to an embodiment, the hinge 302 may include a (2-1)^{th} hinge arm body 3321. The hinge 302 may include a (2-2)^{th} hinge arm body 3322. The hinge 302 may include a second hinge arm wing 3323. The hinge 302 may include a second hinge arm holder 3324. The second hinge arm (e.g., the second hinge arm 332 illustrated in FIG. 9B) may include the (2-1)^{th} hinge arm body 3321, the (2-2)^{th} hinge arm body 3322, the second hinge arm wing 3323, and the second hinge arm holder 3324. The (2-1)^{th} hinge arm body 3321 and the (2-2)^{th} hinge arm body 3322 may be coupled to each other. The (2-1)^{th} hinge arm body 3321 and the (2-2)^{th} hinge arm body 3322 may be interlocked with each other to move together. The second hinge arm wing 3323 may be coupled to the second hinge arm bodies 3321 and 3322 to be relatively rotatable. The second hinge arm bodies 3321 and 3322 may include the (2-1)^{th} hinge arm body 3321 and the (2-2)^{th} hinge arm body 3322. The second hinge arm holder 3324 may be coupled to the second hinge arm wing 3323. The second hinge arm holder 3324 may move together with the second hinge arm wing 3323.

According to an embodiment, the hinge 302 may include a joint 333. The joint 333 may be movably disposed on the base frame 310. The joint 333 may move along a longitudinal direction of the base frame 310. The joint 333 may connect the first hinge arm (e.g., the first hinge arm 331 of FIG. 9B) and the second hinge arm (e.g., the second hinge arm 332 of FIG. 9B). The joint 333 may be referred to as a "spiral joint." The joint 333 may be referred to as a "spiral slider." The first hinge arm 331 and the second hinge arm 332 may be interlocked with each other by the joint 333 to move simultaneously.

According to an embodiment, the hinge 302 may include a first spring structure body 341. The first spring structure body 341 may be movably disposed on the base frame 310. The first spring structure body 341 may be in contact with the first hinge arm (e.g., the first hinge arm 331 of FIG. 9B) and the second hinge arm (e.g., the second hinge arm 332 of FIG. 9B). The first spring structure body 341 may include a cam structure, and the hinge arms 331 and 332 may each include a protrusion that comes into contact with the cam structure. The first spring structure body 341 may be moved by contact with the hinge arms 331 and 332. The hinge 302 may include a first spring 342. The first spring 342 may move together with the first spring structure body 341. The first spring 342 may be compressed by the first spring structure body 341. The expression that "the first spring 342 moves together with the first spring structure body 341" may mean that "the first spring 342 is compressed by the movement of the first spring structure body 341." The first spring 342 may be compressed by the movement of the first spring structure body 341.

According to an embodiment, the hinge 302 may include a second spring structure body 351. The second spring structure body 351 may be movably disposed on the base frame 310. The second spring structure body 351 may be in contact with the first hinge arm (e.g., the first hinge arm 331 of FIG. 9B) and the second hinge arm (e.g., the second hinge arm 332 of FIG. 9B). The second spring structure body 351 may include a cam structure, and the hinge arms 331 and 332 may each include a protrusion that comes into contact with the cam structure. The second spring structure body 351 may be moved by contact with the hinge arms 331 and 332. The hinge 302 may include a second spring 352. The second spring 352 may move together with the second spring structure body 351. The second spring 352 may be compressed by the second spring structure body 351. The expression that "the second spring 352 moves together with the second spring structure body 351" may mean that "the second spring 352 is compressed by the movement of the second spring structure body 351." The second spring 352 may be compressed by the movement of the second spring structure body 351.

According to an embodiment, the hinge 302 may include a guide 360. The guide 360 may be coupled to the hinge housing (e.g., the hinge housing 301 of FIG. 8A). At least a portion of the rotators (e.g., the first and second rotators 321 and 322 of FIG. 9B) may be inserted into the guide 360. The guide 360 may be a component included in the hinge 302 or may be a separate component of the electronic device 200. For example, the guide 360 may be a component coupled to the hinge housing (e.g., the hinge housing 301 of FIG. 8A) separately from the hinge 302.

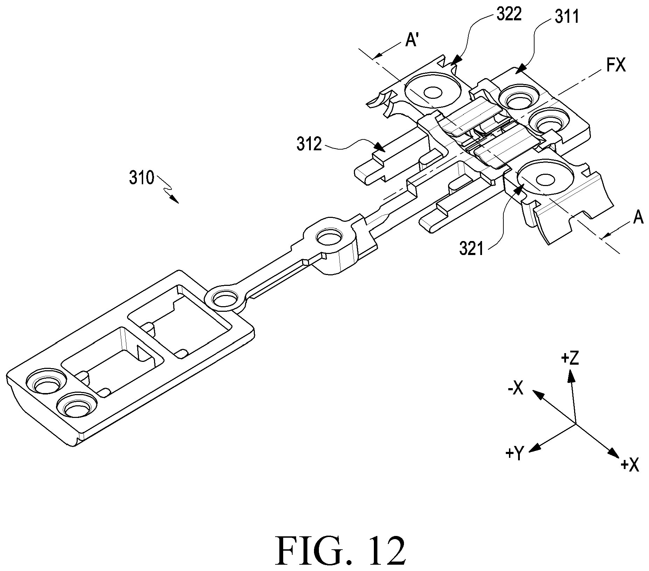

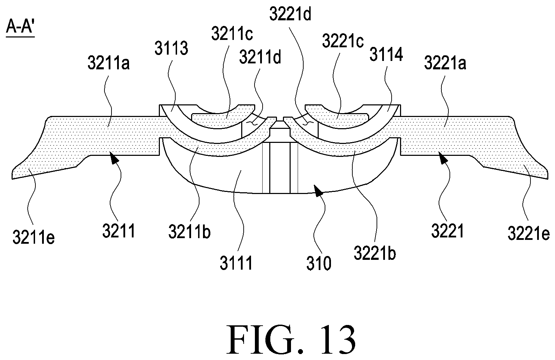

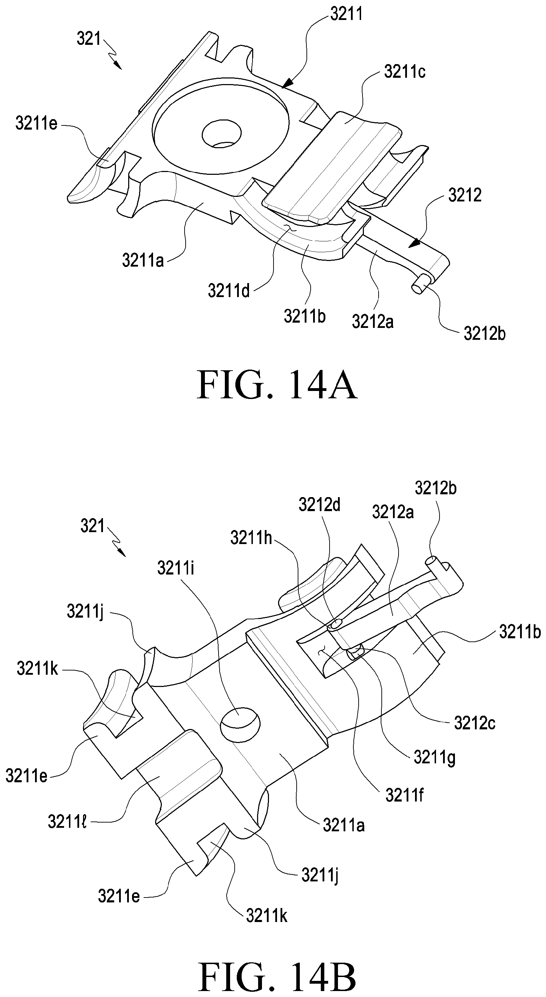

FIG. 11 is a perspective view of the base frame 310. FIG. 12 is a perspective view illustrating a state in which the rotators 321 and 322 are coupled to the base frame 310. FIG. 13 is a cross-sectional view taken along reference line A-A' illustrated in FIG. 12. The components to be described with reference to FIGS. 11 to 13 may be partially or entirely the same as the components described with reference to FIGS. 1 to 10. The components to be described with reference to FIGS. 11 to 13 may be partially or entirely the same as the components to be described with reference to FIGS. 14A to 45.

According to an embodiment, the base frame 310 may include a first frame body 311. The first frame body 311 may be coupled to a hinge housing (e.g., the hinge housing 301 of FIG. 8A). The first frame body 311 may include a first frame body portion 3111 and a first frame body hole 3112 opened in the first frame body portion 3111. The hinge 302 may include a fastening member penetrating the first frame body hole 3112. The first frame body 311 may include a first guide rib 3113 and a second guide rib 3114. The first guide rib 3113 and the second guide rib 3114 may protrude from the first frame body portion 3111. Each of the first guide rib 3113 and the second guide rib 3114 may have an arch shape.

According to an embodiment, the base frame 310 may include a second frame body 312. The second frame body 312 may be spaced apart from the first frame body 311. The rotators 321 and 322 may be disposed between the first frame body 311 and the second frame body 312. The second frame body 312 may include a second frame body portion 3121. The second frame body portion 3121 may be spaced apart from the first frame body portion 3111. The second frame body 312 may include a first guide rib 3122 and a second guide rib 3123. The first guide rib 3122 and the second guide rib 3123 may protrude from the second frame body portion 3121. Each of the first guide rib 3122 and the second guide rib 3123 may have an arch shape.

According to an embodiment, the base frame 310 may include first guide ribs 3113 and 3122 and second guide ribs 3114 and 3123. The first guide ribs 3113 and 3122 may be formed on the first frame body 311 and the second frame body 312, respectively. The first guide ribs 3113 and 3122 may include a (1-1)^{th} guide rib 3113 formed on the first frame body 311 and a (1-2)^{th} guide rib 3122 formed on the second frame body 312. The second guide ribs 3114 and 3123 may be formed on the first frame body 311 and the second frame body 312, respectively. The second guide ribs 3114 and 3123 may include a (2-1)^{th} guide rib 3114 formed on the first frame body 311 and a (2-2)^{th} guide rib 3123 formed on the second frame body 312.

According to an embodiment, the second frame body 312 may include a first frame wall 3124 and a second frame wall 3125. The first frame wall 3124 and the second frame wall 3125 may protrude from the second frame body portion 3121. The first and second frame walls 3124 and 3125 may protrude from the second frame body portion 3121 in a direction opposite to a direction in which the first and second guide ribs 3122 and 3123 protrude. The second frame body 312 may include a first frame protrusion 3126 and a second frame protrusion 3127. The first and second frame protrusions 3126 and 3127 may protrude from the second frame body portion 3121. The first and second frame protrusions 3126 and 3127 may protrude from the second frame body portion 3121 in a direction opposite to a direction in which the first and second guide ribs 3122 and 3123 protrude. The first spring (e.g., the first spring 342 of FIG. 10) may be fitted to each of the first and second frame protrusions 3126 and 3127. At least a portion of the first spring 342 may be surrounded by the first and second frame walls 3124 and 3125.

According to an embodiment, the base frame 310 may include a first bridge 313 and a second bridge 314. The first bridge 313 may be connected to the second frame body 312. The second bridge 314 may be connected to a third frame body 315. A joint (e.g., the joint 333 of FIG. 10) may move along the first bridge 313 or the second bridge 314. The first bridge 313 or the second bridge 314 may be inserted into the joint 333.

According to an embodiment, the base frame 310 may include a third frame body 315. A second spring structure (e.g., the second spring structure 350 of FIG. 9A) may be coupled to the third frame body 315. The third frame body 315 may include a third frame body portion 3151 and a third frame body hole 3152 that are coupled to a hinge housing (e.g., the hinge housing 301 of FIG. 8A). The hinge 302 may include a fastening member penetrating the third frame body hole 3152. The third frame body 315 may include a first spring accommodating portion 3153 and a second spring accommodating portion 3154. A second spring (e.g., the second spring 352 of FIG. 10) may be accommodated in each of the first and second spring accommodating portions 3153 and 3154. The third frame body 315 may include a third frame protrusion 3155 and a fourth frame protrusion 3156. The second spring 352 may be fitted to each of the third and fourth frame protrusions 3155 and 3156.

According to an embodiment, the first rotator 321 and the second rotator 322 may be disposed between the first frame body 311 and the second frame body 312. The first rotator 321 and the second rotator 322 may be rotated between the first frame body 311 and the second frame body 312. The base frame 310 may extend parallel to the folding axis FX. The folding axis FX may pass between the first rotator 321 and the second rotator 322.

According to an embodiment, the first rotator 321 may move along an extending direction of the first guide rib 3113. The first rotator 321 may include a first rotator body 3211. The first guide rib 3113 may be inserted into the first rotator body 3211. The first rotator body 3211 may include a first rotator body portion 3211a and a first rotator guide 3211b extending from the first rotator body portion 3211a. The first rotator guide 3211b may be movably disposed between the first guide rib 3113 and the first frame body portion 3111. The first rotator guide 3211b may have an arch shape. The first rotator guide 3211b may move along the extending direction of the first guide rib 3113. The first rotator body 3211 may include a first rotator support portion 3211c. The first guide rib 3113 may be inserted between the first rotator guide 3211b and the first rotator support portion 3211c. The first rotator support portion 3211c may move along a surface of the first guide rib 3113. The first rotator body 3211 may include a first guide slit 3211d. The first guide slit 3211d may be formed between the first rotator guide 3211b and the first rotator support portion 3211c. The first guide rib 3113 may be inserted into the first guide slit 3211d. The first rotator body 3211 may include a first rotator edge 3211e extending from the first rotator body portion 3211a. The first rotator edge 3211e may extend from the first rotator body portion 3211a in a direction opposite to the first rotator guide 3211b.

According to an embodiment, the second rotator 322 may move along an extending direction of the second guide rib 3114. The second rotator 322 may include a second rotator body 3221. The second guide rib 3114 may be inserted into the second rotator body 3221. The second rotator body 3221 may include a second rotator body portion 3221a and a second rotator guide 3221b extending from the second rotator body portion 3221a. The second rotator guide 3221b may be movably disposed between the second guide rib 3114 and the second frame body portion 3121. The second rotator guide 3221b may have an arch shape. The second rotator guide 3221b may move along the extending direction of the second guide rib 3114. The second rotator body 3221 may include a second rotator support portion 3221c. The second guide rib 3114 may be inserted between the second rotator guide 3221b and the second rotator support portion 3221c. The second rotator support portion 3221c may move along a surface of the second guide rib 3114. The second rotator body 3221 may include a second guide slit 3221d. The second guide slit 3221d may be formed between the second rotator guide 3221b and the second rotator support portion 3221c. The second guide rib 3114 may be inserted into the second guide slit 3221d. The second rotator body 3221 may include a second rotator edge 3221e extending from the second rotator body portion 3221a. The second rotator edge 3221e may extend from the second rotator body portion 3221a in a direction opposite to the second rotator guide 3221b.

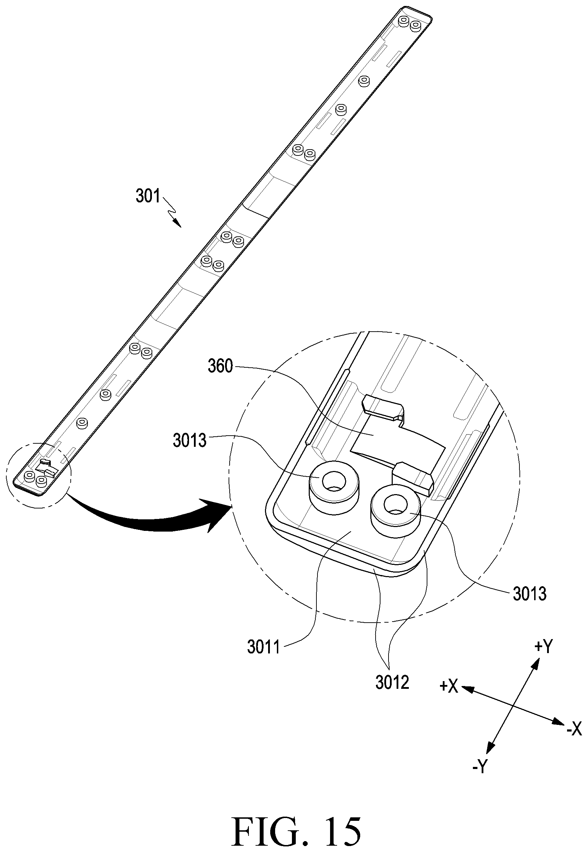

FIG. 14A is a perspective view of the rotator 321. FIG. 14B is a perspective view of the rotator 321 viewed from a direction different from that of FIG. 14A. The components to be described with reference to FIGS. 14A and 14B may be partially or entirely the same as the components described with reference to FIGS. 1 to 13. The components to be described with reference to FIGS. 14A and 14B may be partially or entirely the same as the components to be described with reference to FIGS. 15 to 45.

According to an embodiment, the first rotator 321 may include a first rotator body 3211 and a first link 3212. The second rotator (e.g., the second rotator 322 of FIG. 9B) may include a second rotator body (e.g., the second rotator body 3221 of FIG. 10) and a second link (e.g., the second link 3222 of FIG. 10). Descriptions of the structure of the first rotator body 3211 and the first link 3212 and the coupling relationship therebetween, which will be described below, may equally apply to the structure of the second rotator body 3221 and the second link 3222 and the coupling relationship therebetween.

According to an embodiment, the first rotator body 3211 may include a first rotator body portion 3211a, a first rotator guide 3211b, a first rotator support portion 3211c, a first guide slit 3211d, and a first rotator edge 3211e.

According to an embodiment, the first link 3212 may be rotatably coupled to the first rotator body 3211. According to an embodiment of the disclosure, the first link 3212 may be slidably coupled to the first rotator body 3211. When the first link 3212 is slidably coupled to the first rotator body 3211, a slit into which a portion of the first link 3212 is inserted may be formed in the first rotator body 3211.

According to an embodiment, the first rotator body 3211 may include a first rotator recess 3211f. The first rotator recess 3211f may be recessed in the first rotator guide 3211b. The first rotator recess 3211f may be recessed in a first direction (e.g., the +Z direction of FIGS. 1 to 13C) from a surface of the first rotator guide 3211b. At least a portion of the first link 3212 may be movably disposed in the first rotator recess 3211f.

According to an embodiment, the first rotator body 3211 may include a first link insertion portion 3211g and a second link insertion portion 3211h. The first and second link insertion portions 3211g and 3211h may be formed in the first rotator guide 3211b. The first and second link insertion portions 3211g and 3211h may face a space formed inside the first rotator recess 3211f. The first link insertion portion 3211g and the second link insertion portion 3211h may be spaced apart from each other, and at least a portion of the first link 3212 may be located between the first link insertion portion 3211g and the second link insertion portion 3211h. At least a portion of the first link 3212 may be inserted into each of the first and second link insertion portions 3211g and 3211h.

According to an embodiment, the first link 3212 may include a first link body 3212a. The first link body 3212a may be bar-shaped and extend in one direction. At least a portion of the first link body 3212a may be located inside the first rotator recess 3211f. The first link 3212 may include a first link protrusion 3212b. The first link protrusion 3212b may protrude from the first link body 3212a. The first link 3212 may include a first link shaft 3212c and a second link shaft 3212d. The first and second link shafts 3212c and 3212d may protrude from the first link body 3212a. The first link shaft 3212c may be inserted into the first link insertion portion 3211g. The second link shaft 3212d may be inserted into the second link insertion portion 3211h. The first link shaft 3212c may be rotatably inserted into the first link insertion portion 3211g. The second link shaft 3212d may be rotatably inserted into the second link insertion portion 3211h.

According to an embodiment, the first rotator body 3211 may include a first rotator fastening hole 3211i. The first rotator fastening hole 3211i may be formed in the first rotator body portion 3211a.

According to an embodiment, the first rotator body 3211 may include a first rotator rib 3211j spaced apart from the first rotator edge 3211e. The first rotator body 3211 may include a first rotator rail 3211k formed between the first rotator edge 3211e and the first rotator rib 3211j. The first rotator rail 3211k may extend along the extending direction of the first rotator edge 3211e. The first rotator rail 3211k may refer to a recessed region formed between the first rotator edge 3211e and the first rotator rib 3211j. The first rotator body 3211 may include a first rotator groove 3211L. The first rotator groove 3211L may be recessed in the first rotator body portion 3211a. The first rotator groove 3211L may be recessed in one direction (e.g., the +Z direction of FIGS. 1 to 13C) from the first rotator body portion 3211a. The first rotator groove 3211L may be located between a pair of first rotator edges 3211e.

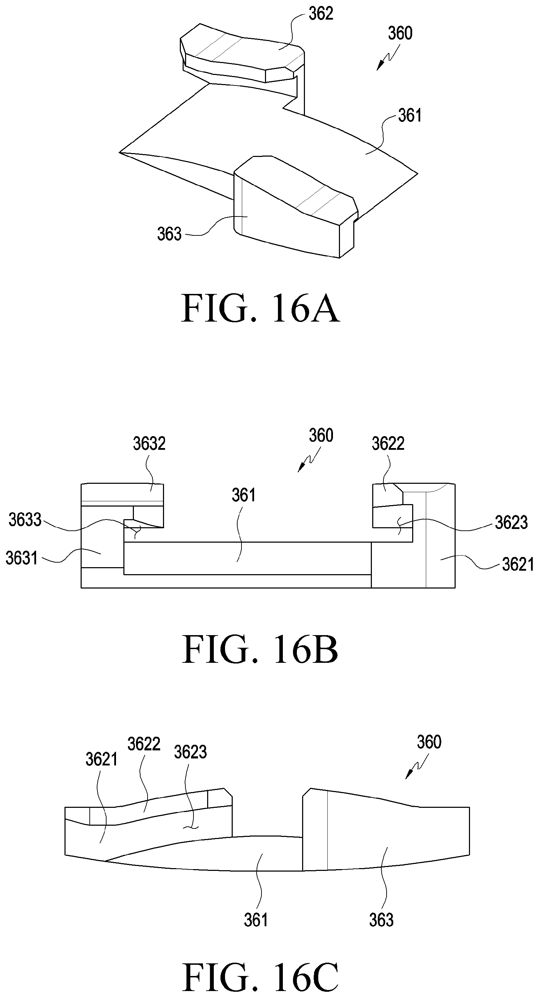

FIG. 15 is a perspective view of the hinge housing 301. The components to be described with reference to FIG. 15 may be partially or entirely the same as the components described with reference to FIGS. 1 to 14B. The components to be described with reference to FIG. 15 may be partially or entirely the same as the components to be described with reference to FIGS. 16A to 45.

According to an embodiment, a guide 360 may be coupled to the hinge housing 301. The guide 360 may be detachable from the hinge housing 301. The guide 360 may be a separate component distinct from the hinge housing 301 or may be a portion of the hinge housing 301 that is integrally formed with the hinge housing 301.

According to an embodiment, the hinge housing 301 may include a base plate 3011. The guide 360 may be coupled to the base plate 3011. The hinge housing 301 may include a housing wall 3012. The housing wall 3012 may protrude from the base plate 3011. The guide 360 may be surrounded by the housing wall 3012. The housing wall 3012 may provide a space in which at least a portion of a hinge (e.g., the hinge 302, 303, or 304 of FIG. 8A) is accommodated. The hinge housing 301 may include a boss 3013. The boss 3013 may protrude from the base plate 3011. The electronic device 200 may include a fastening member inserted into the boss 3013.

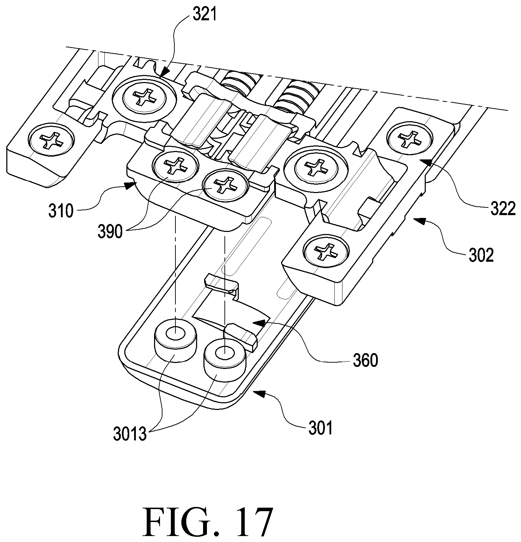

FIG. 16A is a perspective view of the guide 360. FIG. 16B is a side view of the guide 360. FIG. 16C is a side view of the guide 360 as viewed from a direction different from that of FIG. 16B. The components to be described with reference to FIGS. 16A to 16C may be partially or entirely the same as the components described with reference to FIGS. 1 to 15. The components to be described with reference to FIGS. 16A to 16C may be partially or entirely the same as the components to be described with reference to FIGS. 17 to 45.

According to an embodiment, the guide 360 may include a guide body 361. The guide body 361 may extend in a bent manner in one direction (e.g., the +X direction of FIGS. 1 to 15). The guide body 361 may include a curved surface. The guide 360 may include a first guide protrusion 362 and a second guide protrusion 363. The first and second guide protrusions 362 and 363 may protrude from the guide body 361. The first guide protrusion 362 and the second guide protrusion 363 may be spaced apart from each other. The first guide protrusion 362 and the second guide protrusion 363 may be disposed at positions offset from each other with respect to the guide body 361. For example, the first guide protrusion 362 and the second guide protrusion 363 may be disposed at opposite positions with respect to a predetermined axis (e.g., the folding axis FX of FIGS. 1 to 45) that passes through the guide body 361 in one direction (e.g., the +Y direction of FIGS. 1 to 15).

According to an embodiment, the first guide protrusion 362 may include a first guide wall 3621, a first guide roof 3622, and a first guide space 3623. The first guide wall 3621 may protrude from the guide body 361. The first guide roof 3622 may extend from the first guide wall 3621 in a direction intersecting the first guide wall 3621. The first guide space 3623 may be a space surrounded by the first guide wall 3621 and the first guide roof 3622. At least a portion of a first link (e.g., the first link 3212 of FIGS. 14A and 14B) may be inserted into the first guide space 3623. A first link protrusion (e.g., the first link protrusion 3212b of FIG. 14B) may be movably inserted into the first guide space 3623. The first link protrusion 3212b may move along the extending direction of the first guide wall 3621.

According to an embodiment, the second guide protrusion 363 may include a second guide wall 3631, a second guide roof 3632, and a second guide space 3633. The second guide wall 3631 may protrude from the guide body 361. The second guide roof 3632 may extend from the second guide wall 3631 in a direction intersecting the second guide wall 3631. The second guide space 3633 may be a space surrounded by the second guide wall 3631 and the second guide roof 3632. At least a portion of a second link (e.g., the second link 3222 of FIG. 10) may be inserted into the second guide space 3633. The second link 3222 may include a second link protrusion having the same structure as the first link protrusion (e.g., the first link protrusion 3212b of FIG. 14B) of the first link (e.g., the first link 3212 of FIG. 14B). The second link protrusion may be inserted into the second guide space 3633 and may move along an extending direction of the second guide wall 3631.

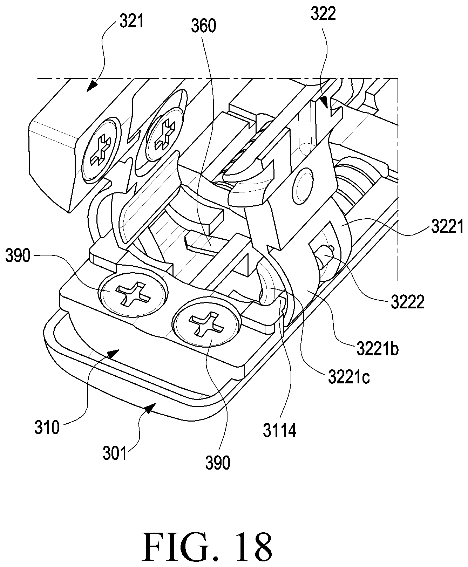

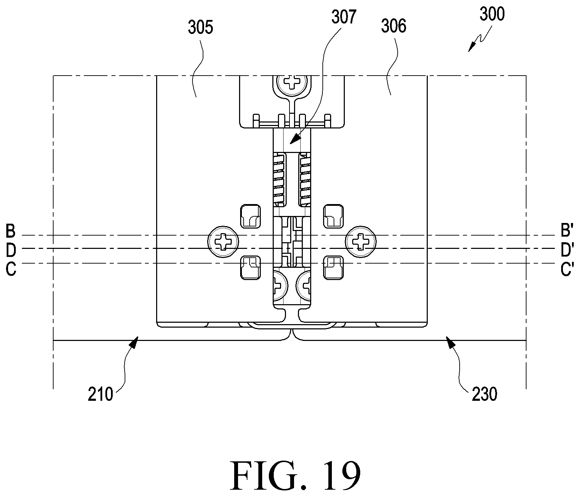

FIG. 17 is a view illustrating a portion of the hinge housing 301 and the hinge 302 in a disassembled state. FIG. 18 is a view illustrating a state in which the rotators 321 and 322 are rotated after the structures of FIG. 17 are assembled. The components to be described with reference to FIGS. 17 and 18 may be partially or entirely the same as the components described with reference to FIGS. 1 to 16C. The components to be described with reference to FIGS. 17 and 18 may be partially or entirely the same as the components to be described with reference to FIGS. 19 to 45.

According to an embodiment, the hinge 302 may be coupled to the hinge housing 301. The hinge 302 may be detachable from the hinge housing 301. The hinge 302 may be coupled to the hinge housing 301 in a state in which the rotators 321 and 322 are assembled to the base frame 310. The electronic device 200 may include a fastening member 390 that couples the hinge 302 and the hinge housing 301. The fastening member 390 may pass through the base frame 310 to be inserted into a boss 3013.

According to an embodiment, the rotators 321 and 322 may be rotatable. The second rotator 322 may include a second rotator body 3221 and a second link 3222. The second link 3222 may be rotatably coupled to the second rotator body 3221. At least a portion of the second link 3222 may be movably disposed on the guide 360. The second guide rib 3114 may be inserted between the second rotator guide 3221b and the second rotator support portion 3221c. The second rotator 322 may be movable along the extending direction of the second guide rib 3114.

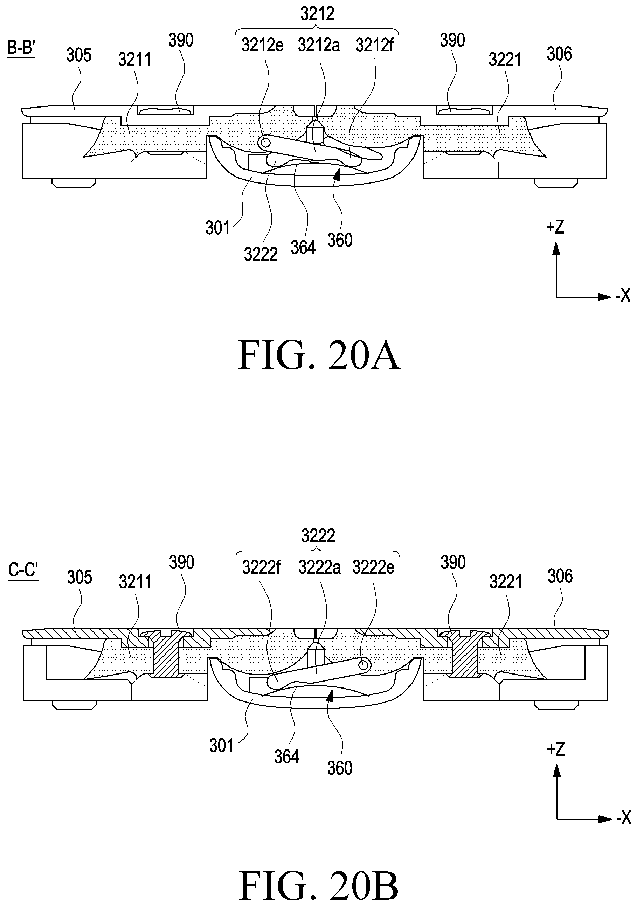

FIG. 19 is an enlarged view of a portion of the hinge assembly 300 in a state in which the hinge assembly 300 is assembled to the first housing 210 and the second housing 230. The components to be described with reference to FIG. 19 may be partially or entirely the same as the components to be described with reference to FIGS. 1 to 18. The components to be described with reference to FIG. 19 may be partially or entirely the same as the components to be described with reference to FIGS. 20A to 45.

According to an embodiment, the hinge assembly 300 may rotatably couple the first housing 210 and the second housing 230. At least a portion of the hinge structure 307 may be disposed between the first housing 210 and the second housing 230. The first support plate 305 may be disposed at a position corresponding to the first housing 210. The second support plate 306 may be disposed at a position corresponding to the second housing 230.

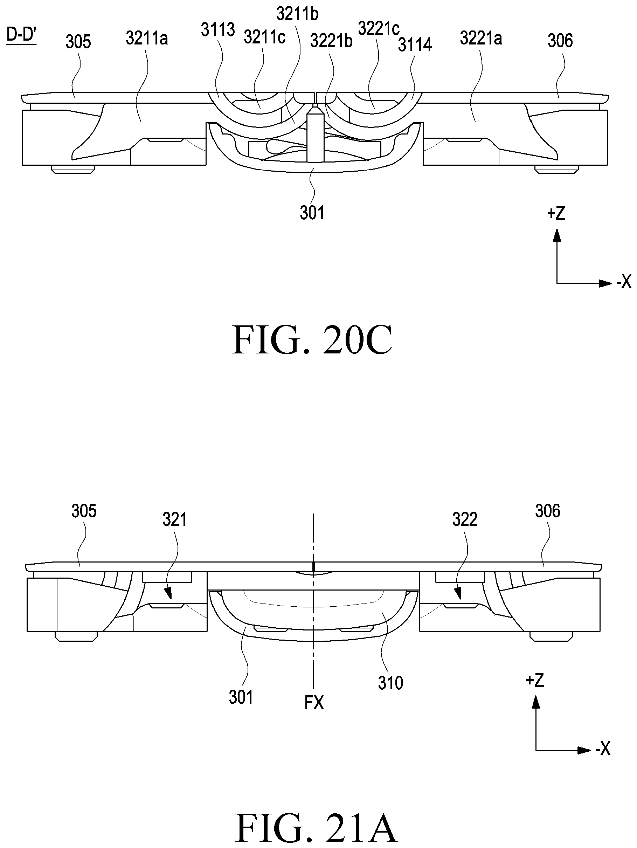

FIG. 20A is a cross-sectional view of a portion of the electronic device 200 taken along the reference line B-B' illustrated in FIG. 19. FIG. 20B is a cross-sectional view of a portion of the electronic device 200 taken along the reference line C-C' illustrated in FIG. 19. FIG. 20C is a cross-sectional view of a portion of the electronic device 200 taken along the reference line D-D' illustrated in FIG. 19. The components to be described with reference to FIGS. 20A to 20C may be partially or entirely the same as the components described with reference to FIGS. 1 to 19. The components to be described with reference to FIGS. 20A to 20C may be partially or entirely the same as the components to be described with reference to FIGS. 21A to 45.

According to an embodiment, the guide 360 may be disposed in the hinge housing 301. Each of the first link 3212 and the second link 3222 may move along the guide 360. For example, each of the first link 3212 and the second link 3222 may move along the guide surface 364 of the guide 360. The guide surface 364 may be formed to be curved toward the rotators 321 and 322.

According to an embodiment, the first link 3212 may be rotatably coupled to the first rotator body 3211. The first link 3212 may include a first link body 3212a that moves relative to the first rotator body 3211. The first link 3212 may include a (1-1)^{th} link part 3212e rotatably coupled to the first rotator body 3211 and a (1-2)^{th} link part 3212f opposite to the (1-1)^{th} link part 3212e. The (1-1)^{th} link part 3212e and the (1-2)^{th} link part 3212f may be portions of the first link body 3212a. The (1-1)^{th} link part 3212e may be rotated relative to the first rotator body 3211. A link shaft (e.g., the link shafts 3212c and 3212d of FIG. 14B) may protrude from the (1-1)^{th} link part 3212e. The (1-2)^{th} link part 3212f may move along the guide surface 364 of the guide 360. The first link protrusion (e.g., the first link protrusion 3212b of FIG. 14B) may protrude from the (1-2)^{th} link part 3212f. The first link protrusion 3212b may be inserted into the first guide space (e.g., the first guide space 3623 of FIG. 16C) and may move along the extending direction of the first guide wall (e.g., the first guide wall 3621 of FIG. 16C). The (1-2)^{th} link part 3212f may move along the guide surface 364 from one direction (e.g., the +X direction) to another direction (e.g., the -X direction). The (1-2)^{th} link part 3212f may move along the guide surface 364 from one direction (e.g., the -X direction) to another direction (e.g., the +X direction). The (1-1)^{th} link part 3212e may be referred to as "a first link part." The (1-2)^{th} link part 3212f may be referred to as "a second link part."

According to an embodiment, the second link 3222 may be rotatably coupled to the second rotator body 3221. The second link 3222 may include a second link body 3222a that moves relative to the second rotator body 3221. The second link 3222 may include a (2-1)^{th} link part 3222e rotatably coupled to the second rotator body 3221 and a (2-2)^{th} link part 3222f opposite to the (2-1)^{th} link part 3222e. The (2-1)^{th} link part 3222e and the (2-2)^{th} link part 3222f may be portions of the second link body 3222a. The (2-1)^{th} link part 3222e may be rotated relative to the second rotator body 3221. The second link 3222 may include link shafts having the same structure as the link shafts 3212c and 3212d of the first link 3212 illustrated in FIG. 14B. The link shafts of the second link 3222 may protrude from the (2-1)^{th} link part 3222e. The (2-2)^{th} link part 3222f may move along the guide surface 364 of the guide 360. The second link 3222 may include a second link protrusion having the same structure as the first link protrusion 3212b of the first link 3212 illustrated in FIG. 14B. The second link protrusion of the second link 3222 may protrude from the (2-2)^{th} link part 3222f. The second link protrusion of the second link 3222 may be inserted into the second guide space (e.g., the second guide space 3633 of FIG. 16B) and may move along the extending direction of the second guide wall (e.g., the second guide wall 3631 of FIG. 16B). The (2-2)^{th} link part 3222f may move along the guide surface 364 from one direction (e.g., the +X direction) to another direction (e.g., the -X direction). The (2-2)^{th} link part 3222f may move along the guide surface 364 from one direction (e.g., the -X direction) to another direction (e.g., the +X direction). The (2-1)^{th} link part 3222e may be referred to as "a first link part." The (2-2)^{th} link part 3222f may be referred to as "a second link part."

According to an embodiment, the first rotator body 3211 may include a first rotator body portion 3211a, a first rotator guide 3211b, and a first rotator support portion 3211c. The first guide rib 3113 may be disposed between the first rotator guide 3211b and the first rotator support portion 3211c. The first rotator guide 3211b and the first rotator support portion 3211c may move along the surface of the first guide rib 3113.

According to an embodiment, the second rotator body 3221 may include a second rotator body portion 3221a, a second rotator guide 3221b, and a second rotator support portion 3221c. The second guide rib 3114 may be disposed between the second rotator guide 3221b and the second rotator support portion 3221c. The second rotator guide 3221b and the second rotator support portion 3221c may move along the surface of the second guide rib 3114.

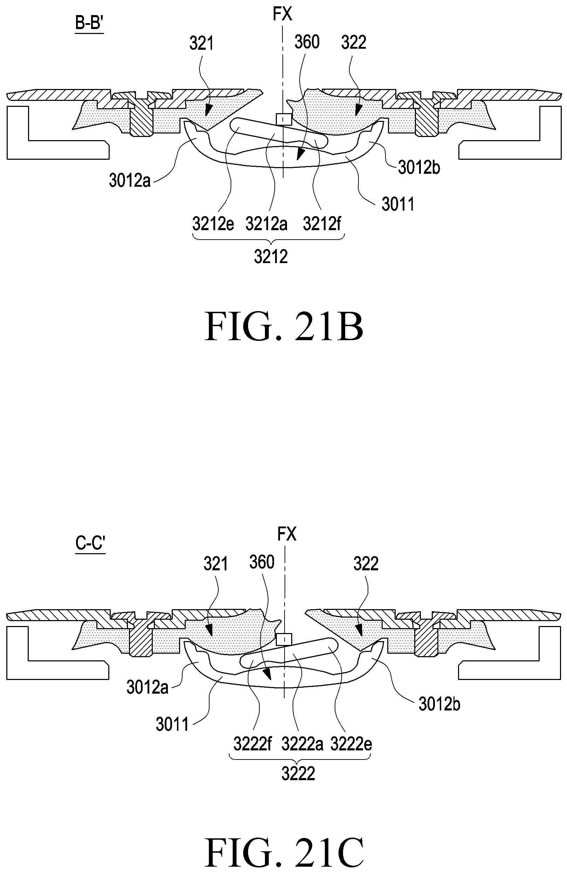

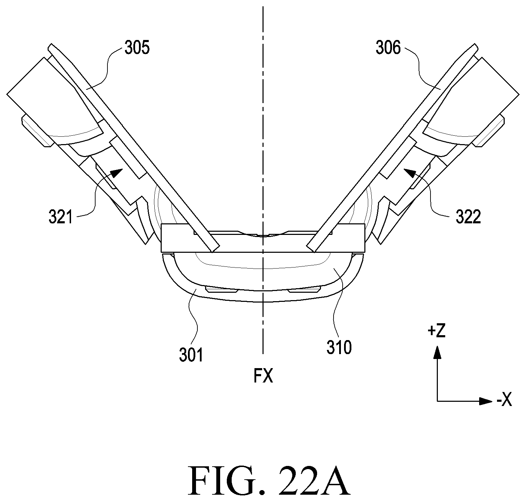

FIG. 21A is a view illustrating a portion of the hinge assembly 300 in a state in which the electronic device 200 is unfolded. FIG. 21B is a view illustrating a portion of a cross-sectional view of the electronic device 200 taken along reference line B-B' illustrated in FIG. 19, in the state of FIG. 21A. FIG. 21C is a view illustrating a portion of a cross-sectional view of the electronic device 200 taken along reference line C-C' illustrated in FIG. 19, in the state of FIG. 21A. The components to be described with reference to FIGS. 21A to 21C may be partially or entirely the same as the components described with reference to FIGS. 1 to 20C. The components to be described with reference to FIGS. 21A to 21C may be partially or entirely the same as the components to be described with reference to FIGS. 22A to 45.

According to an embodiment, the electronic device 200 may be in the unfolded state. The unfolded state of the electronic device 200 may be referred to as a "first state." The first state may be defined as a state in which the angle formed between the first housing (e.g., the first housing 210 of FIG. 7) and the second housing (e.g., the second housing 230 of FIG. 7) is equal to or greater than a first reference value (e.g., 170 degrees). For example, the first state may be defined as a state in which the angle formed between the first housing 210 and the second housing 230 is 180 degrees.

According to an embodiment, in the first state, the angle formed between the first rotator 321 and the second rotator 322 may be equal to or greater than the first reference value (e.g., 170 degrees). In the first state, the angle formed between the first rotator 321 and the second rotator 322 may be 180 degrees.

According to an embodiment, the hinge housing 301 may include a base plate 3011 and a housing wall (e.g., the housing wall 3012 of FIG. 15). The housing wall 3012 may include a first side wall 3012a and a second side wall 3012b. The first side wall 3012a and the second side wall 3012b may be spaced apart from each other. The first link 3212 and the second link 3222 may move between the first side wall 3012a and the second side wall 3012b. The guide 360 may be disposed between the first side wall 3012a and the second side wall 3012b.

According to an embodiment, in the first state, the (1-1)^{th} link part 3212e and the (1-2)^{th} link part 3212f of the first link 3212 may be disposed at positions opposite to each other with respect to the folding axis FX. In the first state, the (1-1)^{th} link part 3212e may be disposed at a position closer to the first side wall 3012a than the second side wall 3012b with respect to the folding axis FX. In the first state, the (1-2)^{th} link part 3212f may be disposed at a position closer to the second side wall 3012b than the first side wall 3012a with respect to the folding axis FX.

According to an embodiment, in the first state, the (2-1)^{th} link part 3222e and the (2-2)^{th} link part 3222f of the second link 3222 may be disposed at positions opposite to each other with respect to the folding axis FX. In the first state, the (2-1)^{th} link part 3222e may be disposed at a position closer to the second side wall 3012b than the first side wall 3012a with respect to the folding axis FX. In the first state, the (2-2)^{th} link part 3222f may be disposed at a position closer to the first side wall 3012a than the second side wall 3012b with respect to the folding axis FX.

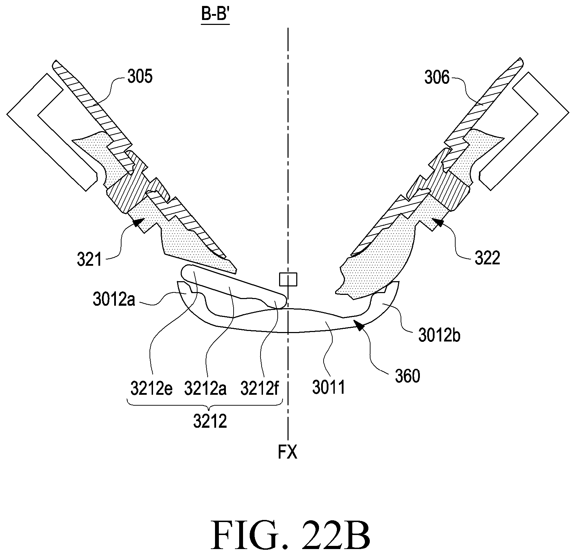

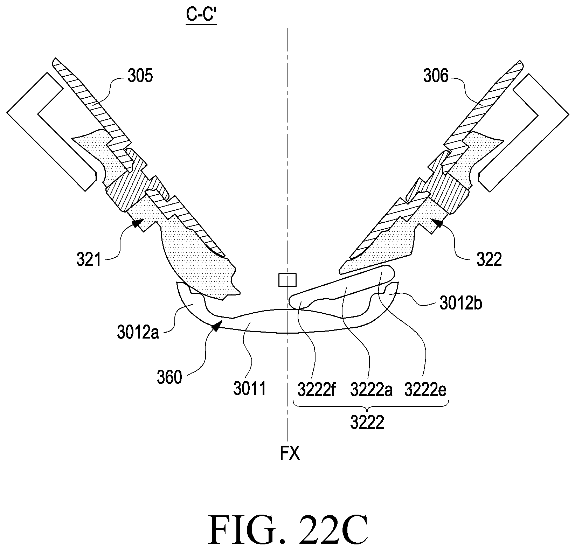

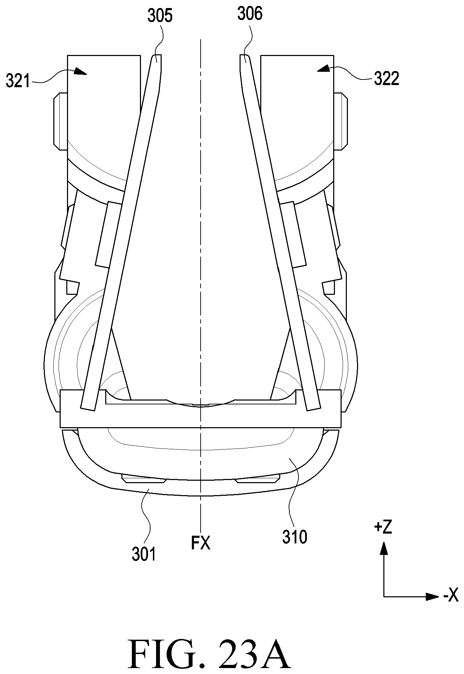

FIG. 22A is a view illustrating a portion of the hinge assembly 300 in a semi-folded state of the electronic device 200. FIG. 22B is a view illustrating a portion of a cross-section of the electronic device 200 taken along reference line B-B' illustrated in FIG. 19, in the state of FIG. 22A. FIG. 22C is a view illustrating a portion of a cross-section of the electronic device 200 taken along reference line C-C' illustrated in FIG. 19, in the state of FIG. 22A. The components to be described with reference to FIGS. 22A to 22C may be partially or entirely the same as the components described with reference to FIGS. 1 to 21C. The components to be described with reference to FIGS. 22A to 22C may be partially or entirely the same as the components to be described with reference to FIGS. 23A to 45.

According to an embodiment, the electronic device 200 may be in a semi-folded state. The semi-folded state of the electronic device 200 may be referred to as a "second state." The second state may be defined as a state in which the angle formed between the first housing (e.g., the first housing 210 of FIG. 7) and the second housing (e.g., the second housing 230 of FIG. 7) is equal to or less than a first reference value (e.g., 170 degrees) and equal to or greater than a second reference value (e.g., 10 degrees). The second state of the electronic device according to an embodiment of the disclosure may be defined as a state in which the angle formed between the first housing 210 and the second housing 220 is between 0 degrees and 180 degrees.

According to an embodiment, in the second state, the angle formed between the first rotator 321 and the second rotator 322 may be equal to or less than the first reference value (e.g., 170 degrees) and equal to or greater than the second reference value (e.g., 10 degrees). In the second state, the angle formed between the first rotator 321 and the second rotator 322 may be between 0 degrees and 180 degrees.

According to an embodiment, in the second state, the (1-1)^{th} link part 3212e and the (1-2)^{th} link part 3212f may be disposed at positions closer to the first side wall 3012a than the second side wall 3012b with respect to the folding axis FX. In the second state, the (1-1)^{th} link part 3212e may be positioned closer to the first side wall 3012a than the (1-2)^{th} link part 3212f. When the electronic device transitions from the first state to the second state, the (1-2)^{th} link part 3212f may move toward the first side wall 3012a along the surface of the guide 360.

According to an embodiment, in the second state, the (2-1)^{th} link part 3222e and the (2-2)^{th} link part 3222f may be disposed at positions closer to the second side wall 3012b than the first side wall 3012a with respect to the folding axis FX. In the second state, the (2-1)^{th} link part 3222e may be positioned closer to the second side wall 3012b than the (2-2)^{th} link part 3222f. When the electronic device transitions from the first state to the second state, the (2-2)^{th} link part 3222f may move toward the second side wall 3012b along the surface of the guide 360.

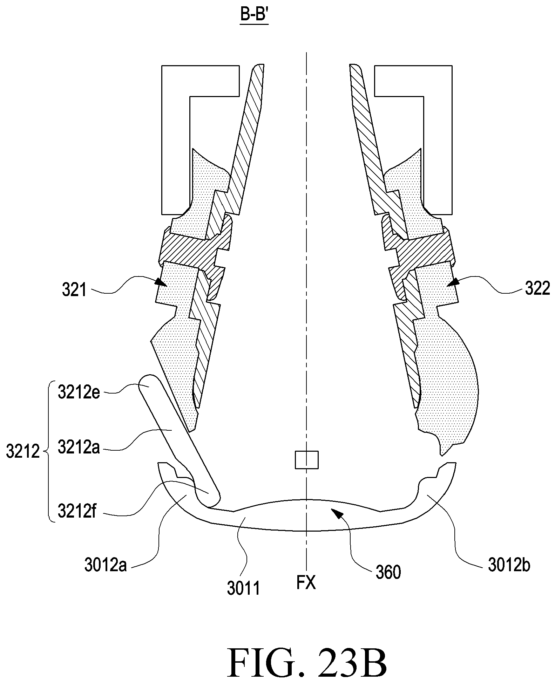

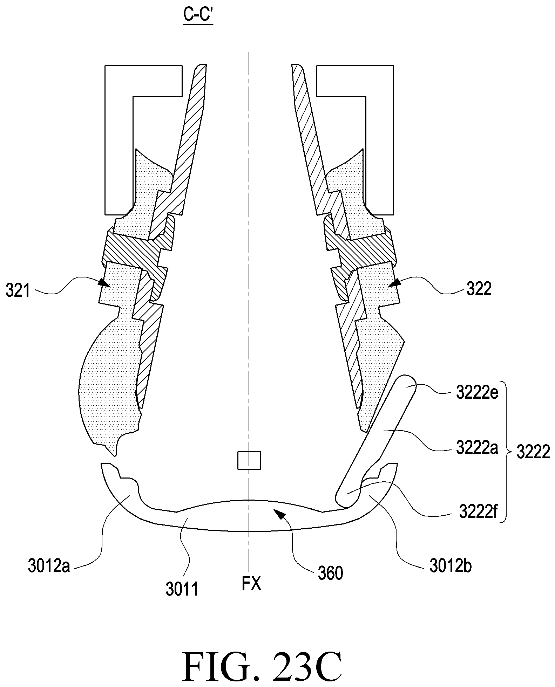

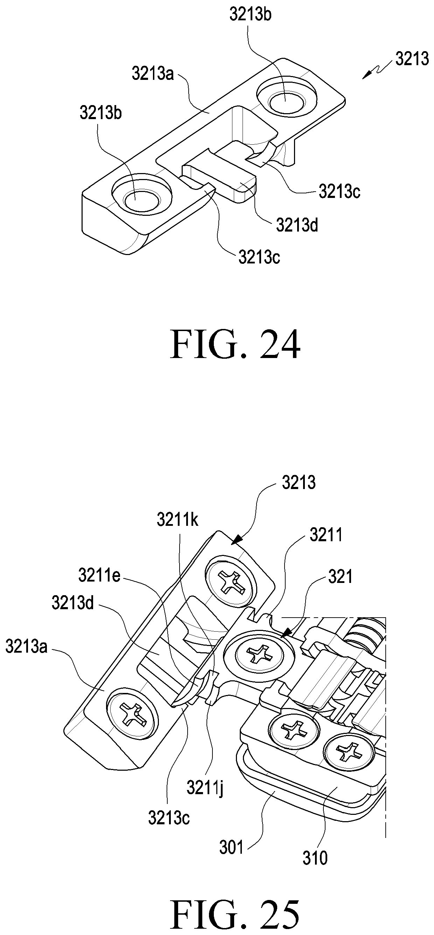

FIG. 23A is a view illustrating a portion of the hinge assembly 300 in a fully-folded state of the electronic device 200. FIG. 23B is a view illustrating a portion of a cross-section of the electronic device 200 taken along the reference line B-B' illustrated in FIG. 19, in the state of FIG. 23A. FIG. 23C is a view illustrating a portion of a cross-section of the electronic device 200 taken along the reference line C-C' illustrated in FIG. 19, in the state of FIG. 23A. The components to be described with reference to FIGS. 23A to 23C may be partially or entirely the same as the components described with reference to FIGS. 1 to 22C. The components to be described with reference to FIGS. 23A to 23C may be partially or entirely the same as the components to be described with reference to FIGS. 24 to 45.

According to an embodiment, the electronic device 200 may be in the fully-folded state. The fully-folded state of the electronic device 200 may be referred to as a "third state." The third state may be defined as a state in which the angle formed between the first housing (e.g., the first housing 210 of FIG. 7) and the second housing (e.g., the second housing 230 of FIG. 7) is equal to or less than the second reference value (e.g., 10 degrees). In an embodiment of the disclosure, the third state of the electronic device may be defined as a state in which the angle formed between the first housing 210 and the second housing 220 is 0 degrees.

According to an embodiment, in the third state, the angle formed between the first rotator 321 and the second rotator 322 may be equal to or less than the second reference value (e.g., 10 degrees). In the third state, the angle formed between the first rotator 321 and the second rotator 322 may be 0 degrees.

According to an embodiment, in the third state, the (1-1)^{th} link part 3212e and the (1-2)^{th} link part 3212f may be disposed at positions closer to the first side wall 3012a than the second side wall 3012b with respect to the folding axis FX. In the third state, the (1-1)^{th} link part 3212e may be located farther from the first side wall 3012a than the (1-2)^{th} link part 3212f. When the electronic device transitions from the second state to the third state, the (1-2)^{th} link part 3212f may move toward the first side wall 3012a along the surface of the guide 360. In the third state, the (1-2)^{th} link part 3212f may be engaged with the first side wall 3012a. In the third state, the (1-2)^{th} link part 3212f may come into contact with the hinge housing 301. In the third state, the movement of the (1-2)^{th} link part 3212f may be restricted by the hinge housing 301.

According to an embodiment, in the third state, the (2-1)^{th} link part 3222e and the (2-2)^{th} link part 3222f may be disposed at positions closer to the second side wall 3012b than the first side wall 3012a with respect to the folding axis FX. In the third state, the (2-1)^{th} link part 3222e may be located farther from the second side wall 3012b than the (2-2)^{th} link part 3222f. When the electronic device transitions from the second state to the third state, the (2-2)^{th} link part 3222f may move toward the second side wall 3012b along the surface of the guide 360. In the third state, the (2-2)^{th} link part 3222f may be engaged with the second side wall 3012b. In the third state, the (2-2)^{th} link part 3222f may come into contact with the hinge housing 301. In the third state, the movement of the (2-2)^{th} link part 3222f may be restricted by the hinge housing 301.

Referring to FIGS. 21A to 23C, when the electronic device 200 transitions from the first state (e.g., the states of FIGS. 21A to 21C) to the third state (e.g., the states of FIGS. 23A to 23C), the (1-2)^{th} link part 3212f of the first link 3212 may move toward the first side wall 3012a along the surface of the guide 360. When the electronic device 200 transitions from the first state (e.g., the state of FIGS. 21A to 21C) to the third state (e.g., the state of FIGS. 23A to 23C), the (2-2)^{th} link part 3222f of the second link 3222 may move toward the second side wall 3012b along the surface of the guide 360. When the electronic device 200 transitions from the third state (e.g., the state of FIGS. 23A to 23C) to the first state (e.g., the state of FIGS. 21A to 21C), the (1-2)^{th} link part 3212f of the first link 3212 may move in a direction away from the first side wall 3012a along the surface of the guide 360. When the electronic device 200 transitions from the third state (e.g., the state of FIGS. 23A to 23C) to the first state (e.g., the state of FIGS. 21A to 21C), the (2-2)^{th} link part 3222f of the second link 3222 may move in a direction away from the second side wall 3012b along the surface of the guide 360.

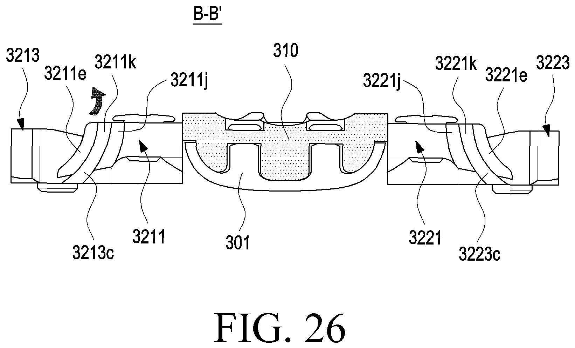

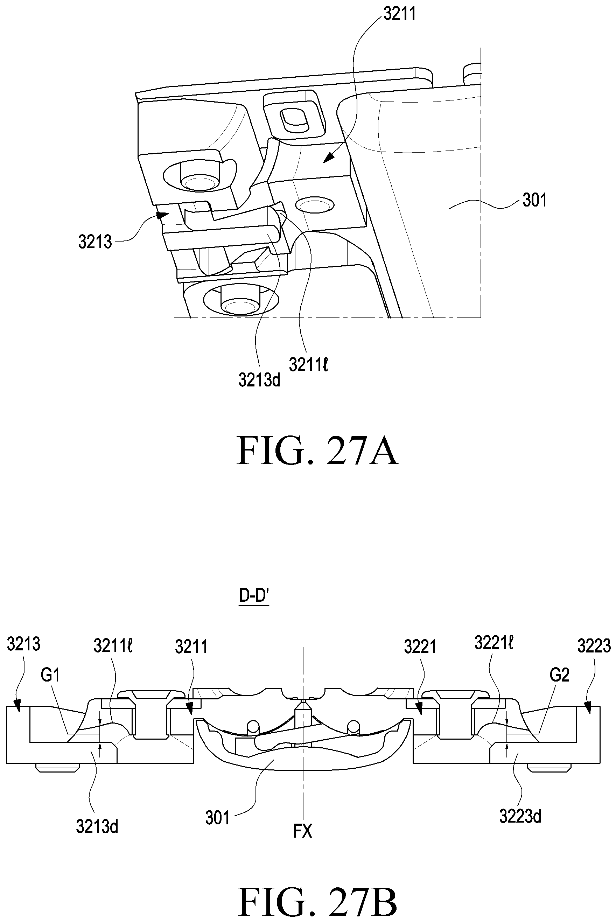

FIG. 24 is a perspective view of the rotator wing 3213. FIG. 25 is a perspective view of the rotator body 3211 and the rotator wing 3213 in a coupled state. FIG. 26 is a cross-sectional view of the structure illustrated in FIG. 25. The components to be described with reference to FIGS. 24 to 26 may be partially or entirely the same as the components described with reference to FIGS. 1 to 23C. The components to be described with reference to FIGS. 24 to 26 may be partially or entirely the same as the components to be described with reference to FIGS. 27A to 45.

According to an embodiment, the first rotator 321 may include a first rotator body 3211 and a first rotator wing 3213 rotatably coupled to the first rotator body 3211. The first rotator wing 3213 may rotate relative to the first rotator body 3211. The descriptions of the structures and coupling relationship of the first rotator body 3211 and the first rotator wing 3213 described below may be equally applied to the structures and coupling relationship of the second rotator body (e.g., the second rotator body 3221 of FIG. 10) and the second rotator wing (e.g., the second rotator wing 3223 of FIG. 10).

According to an embodiment, the first rotator wing 3213 may include a first rotator wing body 3213a and a first rotator wing hole 3213b formed in the first rotator wing body 3213a. The electronic device 200 may include a fastening members that pass through the first rotator wing hole 3213b. The first rotator wing 3213 may be coupled to the first housing (e.g., the first housing 210 of FIG. 7) through the fastening member.

According to an embodiment, the first rotator wing 3213 may include a first rotator wing rib 3213c. The first rotator wing rib 3213c may protrude from the first rotator wing body 3213a. The first rotator wing 3213 may include a pair of first rotator wing ribs 3213c spaced apart from each other.

According to an embodiment, the first rotator wing 3213 may include a first rotator wing holder 3213d. The first rotator wing holder 3213d may protrude from the first rotator wing body 3213a. The first rotator wing holder 3213d may be located between the pair of first rotator wing ribs 3213c.

According to an embodiment, the first rotator wing 3213 may be rotatably coupled to the first rotator body 3211. The first rotator body 3211 may include a first rotator edge 3211e, a first rotator rib 3211j, and a first rotator rail 3211k. The first rotator edge 3211e and the first rotator rib 3211j may be spaced apart from each other, and the first rotator rail 3211k may be formed between the first rotator edge 3211e and the first rotator rib 3211j. The first rotator wing rib 3213c may be inserted between the first rotator edge 3211e and the first rotator rib 3211j. The first rotator wing rib 3213c may move along the first rotator rail 3211k.

According to an embodiment, the second rotator wing 3223 may be rotatably coupled to the second rotator body 3221. The second rotator body 3221 may include a second rotator edge 3221e, a second rotator rib 3221j, and a second rotator rail 3221k. The second rotator edge 3221e and the second rotator rib 3221j may be spaced apart from each other, and the second rotator rail 3221k may be formed between the second rotator edge 3221e and the second rotator rib 3221j. The second rotator wing rib 3223c may be inserted between the second rotator edge 3221e and the second rotator rib 3221j. The second rotator wing rib 3223c may move along the second rotator rail 3221k.

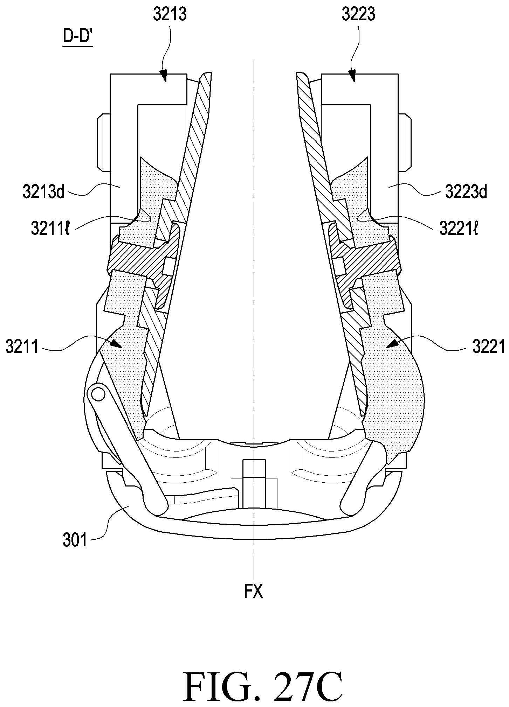

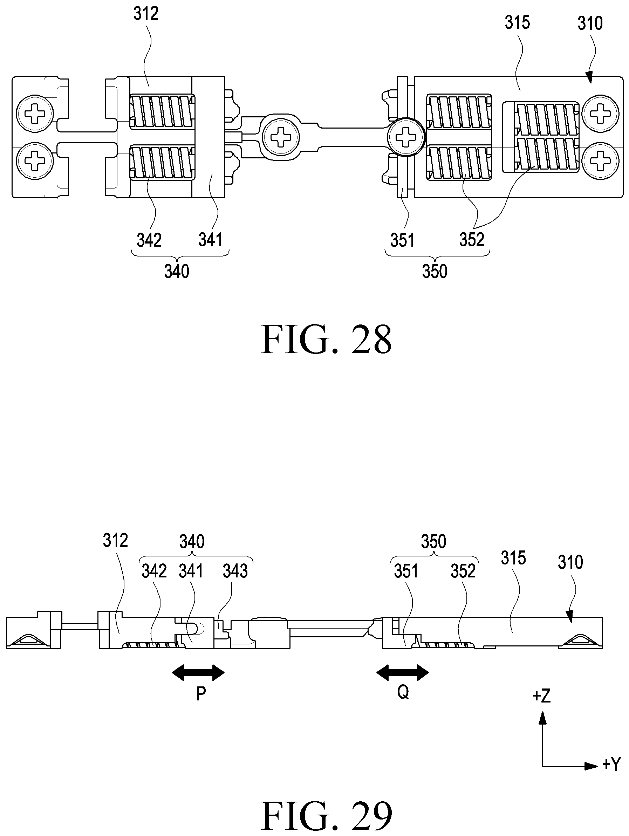

FIG. 27A is a perspective view illustrating the first rotator wing 3213 and the first rotator body 3211 in a coupled state. FIG. 27B is a cross-sectional view of the structure of FIG. 27A in a state in which the electronic device 200 is unfolded. FIG. 27C is a cross-sectional view of the structure of FIG. 27A in a state in which the electronic device 200 is folded. The components to be described with reference to FIGS. 27A to 27C may be partially or entirely the same as the components described with reference to FIGS. 1 to 26. The components to be described with reference to FIGS. 27A to 27C may be partially or entirely the same as the components to be described with reference to FIGS. 28 to 45.

According to an embodiment, the first rotator wing 3213 may include a first rotator wing holder 3213d. The first rotator body 3211 may include a first rotator groove 3211L. The first rotator wing holder 3213d may be received in the first rotator groove 3211L according to the rotation of the first rotator wing 3213.

According to an embodiment, in the state in which the electronic device 200 is unfolded (e.g., the first state), the first rotator wing holder 3213d may be located outside the first rotator groove 3211L. In the unfolded state of the electronic device 200 (e.g., the first state), the first rotator wing holder 3213d and the first rotator groove 3211L may be spaced apart from each other, and a gap G1 may be formed between the first rotator wing holder 3213d and the first rotator groove 3211L.

According to an embodiment, the second rotator 322 may include a second rotator body 3221 and a second rotator wing 3223 rotatably coupled to the second rotator body 3221. The second rotator body 3221 may include a second rotator groove 3221L. The second rotator wing 3223 may include a second rotator wing holder 3223d. The second rotator wing holder 3223d may be received in the second rotator groove 3221L according to the rotation of the second rotator wing 3223.

According to an embodiment, in the state in which the electronic device 200 is unfolded (e.g., the first state), the second rotator wing holder 3223d may be located outside the second rotator groove 3221L. In the state in which the electronic device 200 is unfolded (e.g., the first state), the second rotator wing holder 3223d and the second rotator groove 3221L may be spaced apart from each other, and a gap G2 may be formed between the second rotator wing holder 3223d and the second rotator groove 3221L.

According to an embodiment, in the state in which the electronic device 200 is folded (e.g., the third state), the first rotator wing holder 3213d may be located inside the first rotator groove 3211L. In the state in which the electronic device 200 is folded (e.g., the third state), the first rotator wing holder 3213d may be engaged with the first rotator groove 3211L, and the first rotator groove 3211L may restrict the movement of the first rotator wing 3213.

According to an embodiment, in the state in which the electronic device 200 is folded (e.g., the third state), the second rotator wing holder 3223d may be located inside the second rotator groove 3221L. In the state in which the electronic device 200 is folded (e.g., the third state), the second rotator wing holder 3223d may be engaged with the second rotator groove 3221L, and the second rotator groove 3221L may restrict the movement of the second rotator wing 3223.

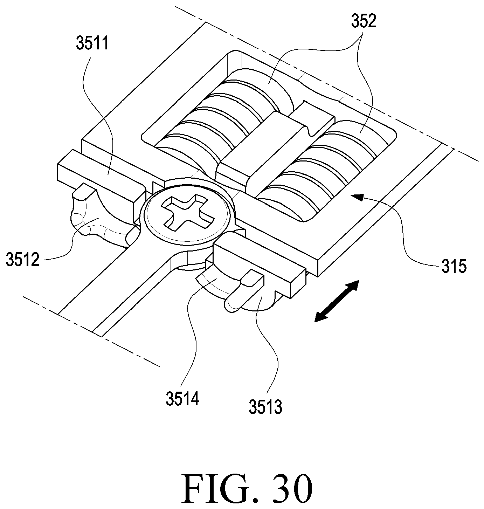

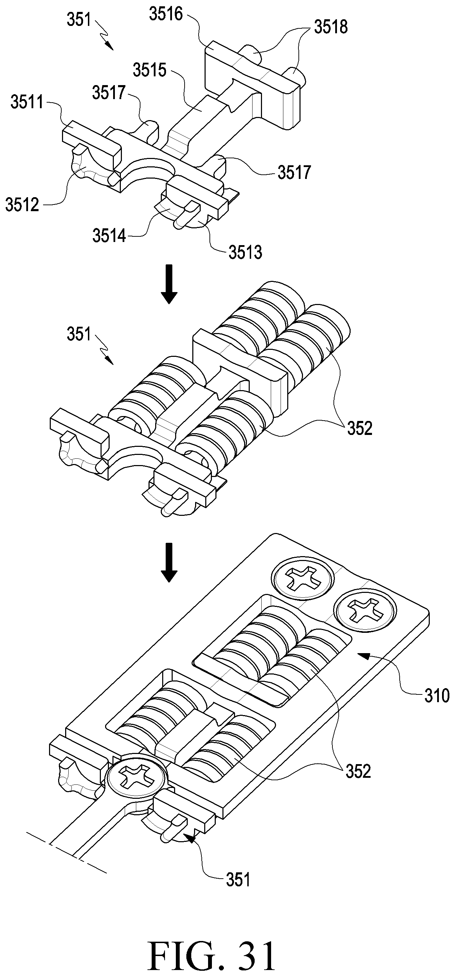

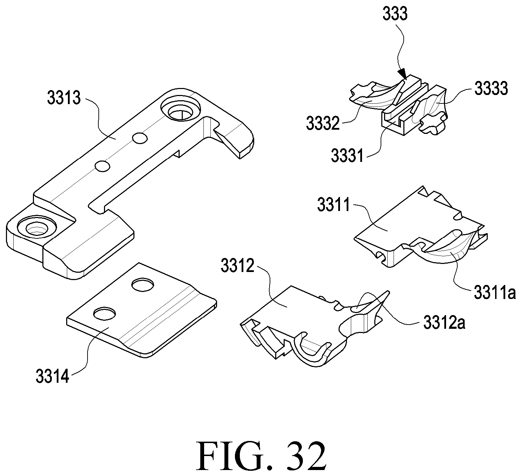

FIG. 28 is a view illustrating the base frame 310, the first spring structure 340, and the second spring structure 350 in the coupled state. FIG. 29 is a side view of the structure of FIG. 28. FIG. 30 is a perspective view of a portion of the structure of FIG. 28. FIG. 31 is a view illustrating an assembly process of the structure of FIG. 28. The components to be described with reference to FIGS. 28 to 31 may be partially or entirely the same as the components described with reference to FIGS. 1 to 27C. The components to be described with reference to FIGS. 28 to 31 may be partially or entirely the same as the components to be described with reference to FIGS. 32 to 45.

According to an embodiment, the first spring structure 340 and the second spring structure 350 may be coupled to the base frame 310. The first spring structure 340 may be coupled to the second frame body 312. The second spring structure 350 may be coupled to the third frame body 315. The first spring structure body 341 may be disposed to be movable in a longitudinal direction (e.g., direction P) of the base frame 310. The first spring 342 may be disposed to be compressible within the second frame body 312. The second spring structure body 351 may be disposed to be movable in a longitudinal direction (e.g., direction Q) of the base frame 310. The second spring 352 may be disposed to be compressible within the third frame body 315.

According to an embodiment, the first spring structure 340 may include a first body protrusion 343. The first body protrusion 343 may protrude from the first spring structure body 341. The first body protrusion 343 may be in contact with the second link assembly (e.g., the second link assembly 330 of FIG. 9A).

According to an embodiment, the second spring structure body 351 may include a (2-1)^{th} spring structure body 3511 and a (2-2)^{th} spring structure body 3513. The (2-1)^{th} spring structure body 3511 and the (2-2)^{th} spring structure body 3513 may be spaced apart from each other. The (2-1)^{th} spring structure body 3511 may be disposed to face a first hinge arm (e.g., the first hinge arm 331 of FIG. 9B). The (2-2)^{th} spring structure body 3513 may be disposed to face a second hinge arm (e.g., the second hinge arm 332 of FIG. 9B).

According to an embodiment, the second spring structure body 351 may include a (2-1)^{th} body protrusion 3512 and a (2-2)^{th} body protrusion 3514. The (2-1)^{th} body protrusion 3512 may protrude from the (2-1)^{th} spring structure body 3511. The (2-2)^{th} body protrusion 3514 may protrude from the (2-2)^{th} spring structure body 3513. The (2-1)^{th} body protrusion 3512 may be in contact with the first hinge arm (e.g., the first hinge arm 331 of FIG. 9B). The (2-2)^{th} body protrusion 3514 may be in contact with the second hinge arm (e.g., the second hinge arm 332 of FIG. 9B).

According to an embodiment, the second spring structure body 351 may include a (2-3)^{th} spring structure body 3516. The (2-3)^{th} spring structure body 3516 may be spaced apart from each of the (2-1)^{th} spring structure body 3511 and the (2-2)^{th} spring structure body 3513. The second spring structure body 351 may include a second spring structure bridge 3515. The second spring structure bridge 3515 may connect the (2-1)^{th} spring structure body 3511 and the (2-3)^{th} spring structure body 3516. The second spring structure bridge 3515 may connect the (2-2)^{th} spring structure body 3513 and the (2-3)^{th} spring structure body 3516. The second spring structure body 351 may include multiple spring holders 3517 and 3518. Each of the multiple spring holders 3517 and 3518 may protrude from one of the (2-1)^{th} spring structure body 3511, the (2-2)^{th} spring structure body 3513, or the (2-3)^{th} spring structure body 3516. Each of the multiple spring holders 3517 and 3518 may be inserted into one of the multiple springs 352.

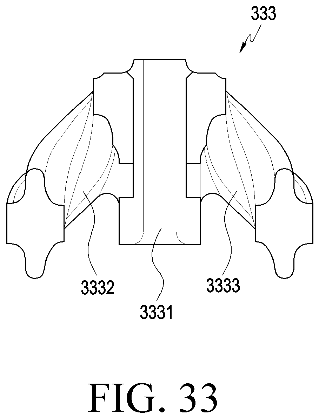

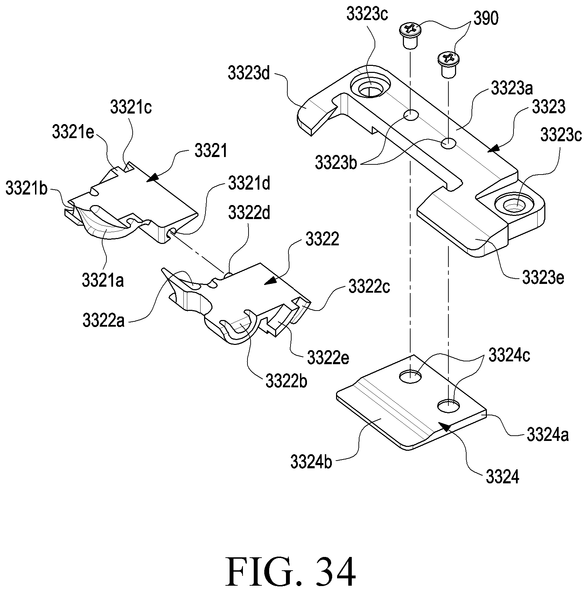

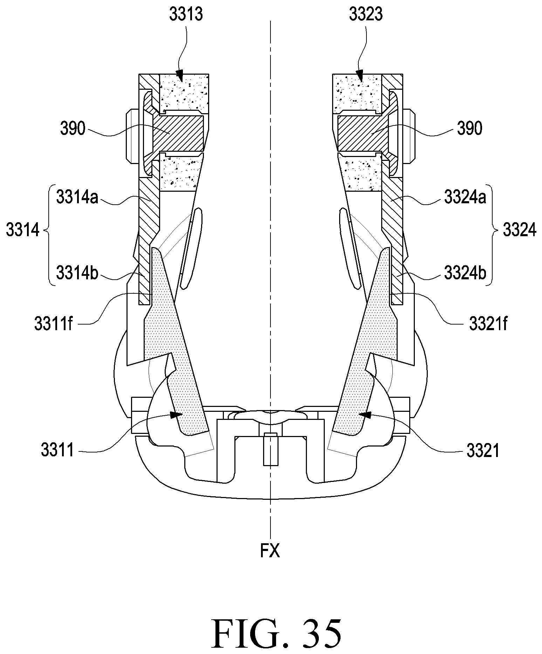

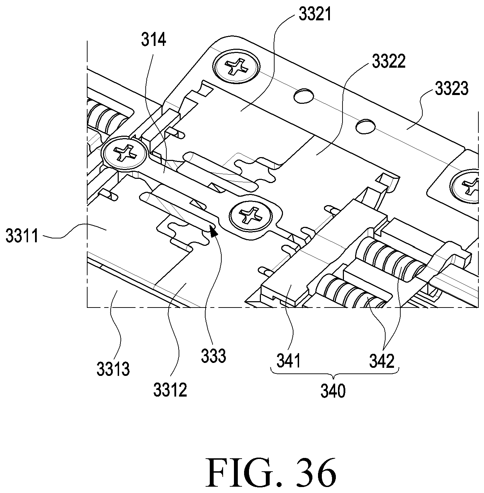

FIG. 32 is a view illustrating a first hinge arm (e.g., the first hinge arm 331 of FIG. 9B) and a joint 333 of a second link assembly (e.g., the second link assembly 330 of FIG. 9A) in a disassembled state. FIG. 33 is a view illustrating the joint 333. FIG. 34 is a view illustrating a second hinge arm (e.g., the second hinge arm 332 of FIG. 9B) of a second link assembly (e.g., the second link assembly 330 of FIG. 9A) in a disassembled state. FIG. 35 is a partial cross-sectional view of an electronic device 200 in a folded state (e.g., the third state). The components to be described with reference to FIGS. 32 to 35 may be partially or entirely the same as the components described with reference to FIGS. 1 to 31. The components to be described with reference to FIGS. 32 to 35 may be partially or entirely the same as the components to be described with reference to FIGS. 36 to 45.

According to an embodiment, the joint 333 may be engaged with the first hinge arm (e.g., the first hinge arm 331 of FIG. 9B) and the second hinge arm (e.g., the second hinge arm 332 of FIG. 9B). The first hinge arm 331 and the second hinge arm 332 may be interlocked in movement by the joint 333. When the first hinge arm 331 is moved, the joint 333 and the second hinge arm 332 may move. When the second hinge arm 332 is moved, the joint 333 and the first hinge arm 331 may move. The first hinge arm 331, the second hinge arm 332, and the joint 333 may also be connected to each other through gear engagement. When the first hinge arm 331 is rotated, the joint 333 engaged with the first hinge arm 331 may move, and the second hinge arm 332 may be rotated by the movement of the joint 333. When the second hinge arm 332 is rotated, the joint 333 engaged with the second hinge arm 332 may move, and the first hinge arm 331 may be rotated by the movement of the joint 333. The rotation of one of the first hinge arm 331 and the second hinge arm 332 connected to each other through the joint 333 may induce rotation of the other.

According to an embodiment, the joint 333 may include a joint body 3331. A first bridge (e.g., the first bridge 313 of FIG. 11) or a second bridge (e.g., the second bridge 314 of FIG. 11) of a base frame (e.g., the base frame 310 of FIG. 11) may be inserted into the joint body 3331. The joint body 3331 may move along the extending direction of the first bridge 313 or the second bridge 314. The joint 333 may move in a direction parallel to a folding axis (e.g., the folding axis FX of FIGS. 1 to 45) by the movement of the first hinge arm 331 or the second hinge arm 332. The joint 333 may include a first joint arm 3332 and a second joint arm 3333. The first joint arm 3332 and the second joint arm 3333 may be connected to the joint body 3331. The first joint arm 3332 and the second joint arm 3333 may extend from the joint body 3331 in directions opposite to each other. Each of the first joint arm 3332 and the second joint arm 3333 may have a spiral surface. The first joint arm 3332 may be engaged with the first hinge arm 331. The second joint arm 3333 may be engaged with the second hinge arm 332.

According to an embodiment, the first hinge arm 331 may include a (1-1)^{th} hinge arm body 3311, a (1-2)^{th} hinge arm body 3312, a first hinge arm wing 3313, and a first hinge arm holder 3314.

According to an embodiment, the first hinge arm bodies 3311 and 3312 may have spiral surfaces. The first hinge arm bodies 3311 and 3312 may be engaged with the first joint arm 3332. The (1-1)^{th} hinge arm body 3311 may include a (1-1)^{th} spiral structure 3311a engaged with the first joint arm 3332. The (1-2)^{th} hinge arm body 3312 may include a (1-2)^{th} spiral structure 3312a engaged with the first joint arm 3332. The first joint arm 3332 may be disposed between the (1-1)^{th} spiral structure 3311a and the (1-2)^{th} spiral structure 3312a.

According to an embodiment, the second hinge arm 332 may include a (2-1)^{th} hinge arm body 3321, a (2-2)^{th} hinge arm body 3322, a second hinge arm wing 3323, and a second hinge arm holder 3324.

According to an embodiment, the second hinge arm bodies 3321 and 3322 may have spiral surfaces. The second hinge arm bodies 3321 and 3322 may be engaged with the second joint arm 3333. The (2-1)^{th} hinge arm body 3321 may include a (2-1)^{th} spiral structure 3321a engaged with the second joint arm 3333. The (2-2)^{th} hinge arm body 3322 may include a (2-2)^{th} spiral structure 3322a engaged with the second joint arm 3333. The second joint arm 3333 may be disposed between the (2-1)^{th} spiral structure 3321a and the (2-2)^{th} spiral structure 3322a. According to an embodiment of the disclosure, the (2-1)^{th} hinge arm body 3321 and the (2-2)^{th} hinge arm body 3322 may be connected to each other through a gear engagement structure. For example, according to an embodiment of the disclosure, a gear (not illustrated) may be disposed between the (2-1)^{th} hinge arm body 3321 and the (2-2)^{th} hinge arm body 3322 to be engaged with the (2-1)^{th} and (2-2)^{th} hinge arm bodies 3321 and 3322.

According to an embodiment, the (2-1)^{th} hinge arm body 3321 may include a (2-1)^{th} hinge arm protrusion 3321b. The (2-1)^{th} hinge arm protrusion 3321b may protrude toward one of the first spring structure (e.g., the first spring structure 340 of FIG. 9A) or the second spring structure (e.g., the second spring structure 350 of FIG. 9A). The (2-1)^{th} hinge arm body 3321 may include a (2-1)^{th} hinge arm body part 3321c. The (2-1)^{th} hinge arm body part 3321c may have an arch shape. The (2-1)^{th} hinge arm body part 3321c may protrude in a direction opposite to a direction in which the (2-2)^{th} hinge arm body 3322 is located. The (2-1)^{th} hinge arm body 3321 may include a (2-1)^{th} hinge arm guide 3321e. The (2-1)^{th} hinge arm guide 3321e may have an arch shape. The (2-1)^{th} hinge arm guide 3321e may protrude in a direction opposite to a direction in which the (2-2)^{th} hinge arm body 3322 is located. The (2-1)^{th} hinge arm guide 3321e may be spaced apart from the (2-1)^{th} hinge arm body part 3321c. The (2-1)^{th} hinge arm body 3321 may include a connector hole 3321d. The connector hole 3321d may face the (2-2)^{th} hinge arm body 3322.

According to an embodiment, the (2-2)^{th} hinge arm body 3322 may include a (2-2)^{th} hinge arm protrusion 3322b. The (2-2)^{th} hinge arm protrusion 3322b may protrude toward one of the first spring structure (e.g., the first spring structure 340 of FIG. 9A) or the second spring structure (e.g., the second spring structure 350 of FIG. 9A). The (2-2)^{th} hinge arm body 3322 may include a (2-2)^{th} hinge arm body part 3322c. The (2-2)^{th} hinge arm body part 3322c may have an arch shape. The (2-2)^{th} hinge arm body part 3322c may protrude in a direction opposite to a direction in which the (2-1)^{th} hinge arm body 3321 is located. The (2-2)^{th} hinge arm body 3322 may include a (2-2)^{th} hinge arm guide 3322e. The (2-2)^{th} hinge arm guide 3322e may have an arch shape. The (2-2)^{th} hinge arm guide 3322e may protrude in a direction opposite to a direction in which the (2-1)^{th} hinge arm body 3321 is located. The (2-2)^{th} hinge arm guide 3322e may be spaced apart from the (2-2)^{th} hinge arm body part 3322c. The (2-2)^{th} hinge arm body 3322 may include a connector 3322d. The connector 3322d may face the (2-1)^{th} hinge arm body 3321. The connector 3322d may be inserted into the connector hole 3321d. The (2-1)^{th} hinge arm body 3321 and the (2-2)^{th} hinge arm body 3322 may be connected to each other by inserting the connector 3322d into the connector hole 3321d. The (2-1)^{th} hinge arm body 3321 and the (2-2)^{th} hinge arm body 3322 may be connected to each other through the connector 3322d, and the connector 3322d may link the movements of the (2-1)^{th} hinge arm body 3321 and the (2-2)^{th} hinge arm body 3322.

According to an embodiment, the second hinge arm wing 3323 may include a second hinge arm wing body 3323a and a second hinge arm wing hole 3323b formed in the second hinge arm wing body 3323a. The second hinge arm wing 3323 may include a second link-connection hole 3323c formed in the second hinge arm wing body 3323a. The second hinge arm wing 3323 may include second hinge arm wing ribs 3323d and 3323e. The second hinge arm wing ribs 3323d and 3323e may protrude from the second hinge arm wing body 3323a toward the second hinge arm bodies 3321 and 3322. The second hinge arm wing 3323 may include a (2-1)^{th} hinge arm wing rib 3323d movably coupled to the (2-1)^{th} hinge arm body 3321. The second hinge arm wing 3323 may include a (2-2)^{th} hinge arm wing rib 3323e movably coupled to the (2-2)^{th} hinge arm body 3322. The (2-1)^{th} hinge arm wing rib 3323d may be inserted between the (2-1)^{th} hinge arm body part 3321c and the (2-1)^{th} hinge arm guide 3321e. The (2-1)^{th} hinge arm wing rib 3323d may move along the extending direction of the (2-1)^{th} hinge arm body part 3321c and the (2-1)^{th} hinge arm guide 3321e. The (2-2)^{th} hinge arm wing rib 3323e may be inserted between the (2-2)^{th} hinge arm body part 3322c and the (2-2)^{th} hinge arm guide 3322e. The (2-2)^{th} hinge arm wing rib 3323e may move along the extending direction of the (2-2)^{th} hinge arm body part 3322c and the (2-2)^{th} hinge arm guide 3322e.

According to an embodiment, the second hinge arm holder 3324 may be coupled to the second hinge arm wing 3323. The second hinge arm holder 3324 may include a second hinge arm holder body 3324a and a second hinge arm holder hole 3324c formed in the second hinge arm holder body 3324a. The electronic device 200 may include a fastening member 390 penetrating the second hinge arm wing hole 3323b and the second hinge arm holder hole 3324c. The second hinge arm holder 3324 may include a second stopper 3324b protruding from the second hinge arm holder body 3324a.

According to an embodiment, descriptions of the components (e.g., the (2-1)^{th} hinge arm body 3321, the (2-2)^{th} hinge arm body 3322, the second hinge arm wing 3323, and the second hinge arm holder 3324) included in the above-described second hinge arm 332 may be equally applied to the components (e.g., the (1-1)^{th} hinge arm body 3311, the (1-2)^{th} hinge arm body 3312, the first hinge arm wing 3313, and the first hinge arm holder 3314 of FIG. 32) included in the first hinge arm (e.g., the first hinge arm 331 of FIG. 9B).

According to an embodiment, the first hinge arm body 3311 and the second hinge arm body 3321 may be rotated about the folding axis FX. The first hinge arm wing 3313 and the second hinge arm wing 3323 may be rotated about the folding axis FX. The first hinge arm body 3311 and the second hinge arm body 3321 may be rotated about a rotation axis. The rotation axis may be a shaft having a physical shape or may represent the center of a virtual rotational trajectory. The first hinge arm wing 3313 and the second hinge arm wing 3323 may be rotated about the rotation axis. The rotation axis may be a shaft having a physical shape or may represent the center of a virtual rotational trajectory.

According to an embodiment, the first hinge arm holder 3314 may include a first hinge arm holder body 3314a and a first stopper 3314b extending from the first hinge arm holder body 3314a. The second hinge arm holder 3324 may include a second hinge arm holder body 3324a and a second stopper 3324b extending from the second hinge arm holder body 3324a. The first hinge arm body 3311 may include a first hinge arm recess 3311f. The first hinge arm recess 3311f may face the first stopper 3314b. In the folded state of the electronic device 200 (e.g., the third state), the first stopper 3314b may be engaged with the first hinge arm recess 3311f. In the folded state of the electronic device 200 (e.g., the third state), the first hinge arm recess 3311f may restrict the movement of the first stopper 3314b. The second hinge arm body 3321 may include a second hinge arm recess 3321f. The second hinge arm recess 3321f may face the second stopper 3324b. In the folded state of the electronic device 200 (e.g., the third state), the second stopper 3324b may be engaged with the second hinge arm recess 3321f. In the folded state of the electronic device 200 (e.g., the third state), the second hinge arm recess 3321f may restrict the movement of the second stopper 3324b.

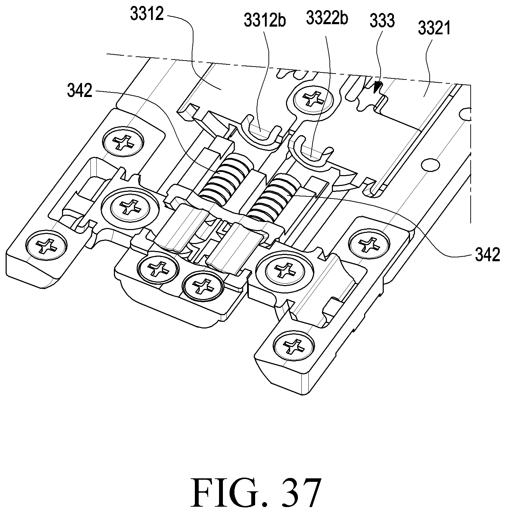

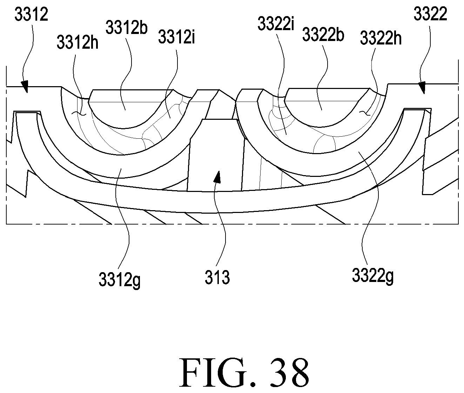

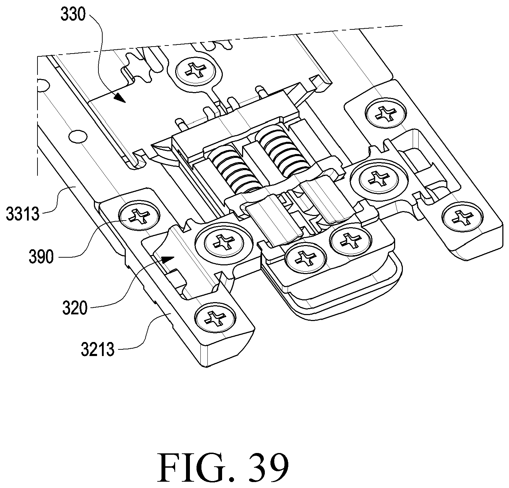

FIG. 36 is a view illustrating the second hinge assembly (e.g., the second hinge assembly 330 of FIG. 9A) and the first spring structure 340 in a coupled state. FIG. 37 is a view illustrating a state in which the first spring structure body 341 is removed from the state of FIG. 36. FIG. 38 is an enlarged perspective view illustrating a portion of FIG. 37. The components to be described with reference to FIGS. 36 to 38 may be partially or entirely the same as the components described with reference to FIGS. 1 to 35. The components to be described with reference to FIGS. 36 to 38 may be partially or entirely the same as the components described with reference to FIGS. 39 to 45.

According to an embodiment, the first spring structure 340 may be movably connected to the second hinge assembly 330. The first spring structure body 341 may be movably connected to the second hinge assembly 330. The first spring structure 340 may be movably connected to the (1-2)^{th} hinge arm body 3312 and the (2-2)^{th} hinge arm body 3322. The first spring structure 340 may be moved by the movements of components (e.g., the (1-1)^{th} hinge arm body 3311, the (1-2)^{th} hinge arm body 3312, the (2-1)^{th} hinge arm body 3321, the (2-2)^{th} hinge arm body 3322, and the joint 333) constituting the second hinge assembly 330. The first spring body 341 of the first spring structure 340 may be moved in one direction (e.g., the +Y direction of FIGS. 1 to 35) by the rotation of the second hinge assembly 330. By the movement of the first spring structure 340, the first spring 342 may be compressed.

According to an embodiment, the first spring structure body 341 may be disposed between the first spring 342 and the first and second hinge arm bodies 3312 and 3322.

According to an embodiment, the (1-2)^{th} hinge arm body 3312 may include a (1-2)^{th} hinge arm protrusion 3312b. The (2-2)^{th} hinge arm body 3322 may include a (2-2)^{th} hinge arm protrusion 3322b. The (1-2)^{th} hinge arm protrusion 3312b may face the first spring structure body 341. The (2-2)^{th} hinge arm protrusion 3322b may face the first spring structure body 341.

According to an embodiment, the (1-2)^{th} hinge arm body 3312 may include a (1-2)^{th} hinge arm end portion 3312g. The (1-2)^{th} hinge arm end portion 3312g may extend to surround the (1-2)^{th} hinge arm protrusion 3312b. The (1-2)^{th} hinge arm end portion 3312g may have an arch shape. The (1-2)^{th} hinge arm end portion 3312g may be spaced apart from the (1-2)^{th} hinge arm protrusion 3312b. A first guide slit 3312h into which at least a portion of the first spring structure body 341 is inserted may be formed between the (1-2)^{th} hinge arm end portion 3312g and the (1-2)^{th} hinge arm protrusion 3312b. The (1-2)^{th} hinge arm body 3312 may include a first cam protrusion 3312i protruding toward the first guide slit 3312h. The first cam protrusion 3312i may be formed between the (1-2)^{th} hinge arm end portion 3312g and the (1-2)^{th} hinge arm protrusion 3312b. The first spring structure body 341 may include a (1-1)^{th} body protrusion and a (1-2)^{th} body protrusion, which are the same as the (2-1)^{th} body protrusion 3512 and the (2-2)^{th} body protrusion 3514 illustrated in FIG. 30. The (1-1)^{th} body protrusion may be inserted into the first guide slit 3312h. The (1-1)^{th} body protrusion may come into contact with the first cam protrusion 3312i by the rotation of the (1-2)^{th} hinge arm body 3312, and the first cam protrusion 3312i may come into contact with the (1-1)^{th} body protrusion and push the first spring structure body 341 toward the first spring 342. The first spring 342 may be compressed by the first spring structure body 341 pushed by the first cam protrusion 3312i.

According to an embodiment, the (2-2)^{th} hinge arm body 3322 may include a (2-2)^{th} hinge arm end portion 3322g. The (2-2)^{th} hinge arm end portion 3322g may extend to surround the (2-2)^{th} hinge arm protrusion 3322b. The (2-2)^{th} hinge arm end portion 3322g may have an arch shape. The (2-2)^{th} hinge arm end portion 3322g may be spaced apart from the (2-2)^{th} hinge arm protrusion 3322b. A second guide slit 3322h, into which at least a portion of the first spring structure body 341 is inserted, may be formed between the (2-2)^{th} hinge arm end portion 3322g and the (2-2)^{th} hinge arm protrusion 3322b. The (2-2)^{th} hinge arm body 3322 may include a second cam protrusion 3322i protruding toward the second guide slit 3322h. The second cam protrusion 3322i may be formed between the (2-2)^{th} hinge arm end portion 3322g and the (2-2)^{th} hinge arm protrusion 3322b. The first spring structure body 341 may include a (1-1)^{th} body protrusion and a (1-2)^{th} body protrusion, which are the same as the (2-1)^{th} body protrusion 3512 and the (2-2)^{th} body protrusion 3514 illustrated in FIG. 30. The (1-2)^{th} body protrusion may be inserted into the second guide slit 3322h. The (1-2)^{th} body protrusion may come into contact with the second cam protrusion 3322i by the rotation of the (2-2)^{th} hinge arm body 3322, and the second cam protrusion 3322i may come into contact with the (1-2)^{th} body protrusion and push the first spring structure body 341 toward the first spring 342. The first spring 342 may be compressed by the first spring structure body 341 pushed by the second cam protrusion 3322i.

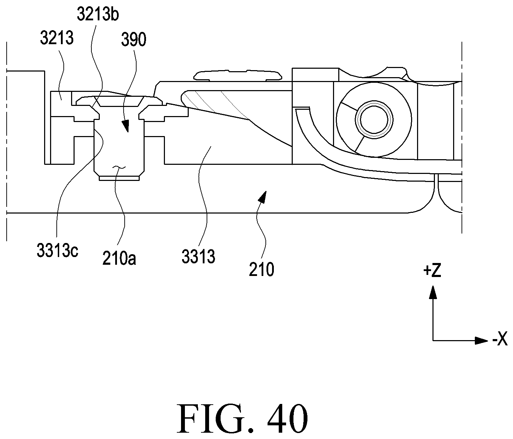

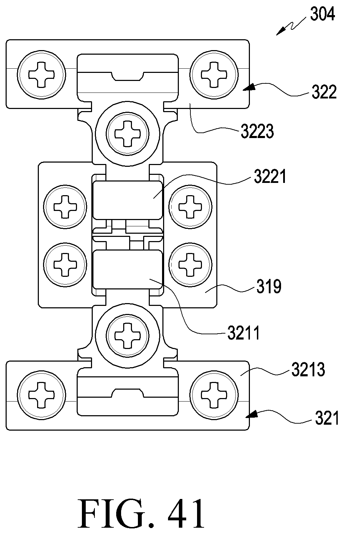

FIG. 39 is a view of a portion of the hinge assembly 300 in a state in which the first link assembly 320 and the second link assembly 330 are coupled to each other. FIG. 40 is a partial cross-sectional view of the structure illustrated in FIG. 39. The components to be described with reference to FIGS. 39 and 40 may be partially or entirely the same as the components described with reference to FIGS. 1 to 38. The components to be described with reference to FIGS. 39 and 40 may be partially or entirely the same as the components to be described with reference to FIGS. 41 to 45.

According to an embodiment, the first link assembly 320 and the second link assembly 330 may be coupled to each other. The first link assembly 320 and the second link assembly 330 may move together. The rotation of the first link assembly 320 and the rotation of the second link assembly 330 may be linked to each other. The first rotator wing 3213 and the first hinge arm wing 3313 may be coupled to each other. The electronic device 200 may include a fastening member 390 penetrating the first rotator wing 3213 and the first hinge arm wing 3313. The fastening member 390 may penetrate the first rotator wing hole 3213b of the first rotator wing 3213 and the first hinge arm wing hole 3313c of the first hinge arm wing 3313. The coupling method between the first rotator wing 3213 and the first hinge arm wing 3313 described above may be equally applied to the coupling structure between the second rotator wing (e.g., the second rotator wing 3223 of FIG. 10) and the second hinge arm wing (e.g., the second hinge arm wing 3323 of FIG. 10). For example, the electronic device 200 may include a fastening member 390 penetrating the second rotator wing 3223 and the second hinge arm wing 3323.

According to an embodiment, the first rotator wing 3213 and the first hinge arm wing 3313 may be coupled to the first housing 210. The first housing 210 may include a first housing hole 210a penetrated by the fastening member 390. The fastening member 390 may couple the first housing 210 to the first rotator wing 3213 and the first hinge arm wing 3313. The first housing 210, the first rotator wing 3213, and the first hinge arm wing 3313 may move together. The rotations of the first housing 210, the first rotator wing 3213, and the first hinge arm wing 3313 may be linked to each other. The above-described coupling structure among the first housing 210, the first rotator wing 3213, and the first hinge arm wing 3313 may be equally applied to the coupling structure among the second housing (e.g., the second housing 230 of FIG. 7), the second rotator wing (e.g., the second rotator wing 3223 of FIG. 10), and the second hinge arm wing (e.g., the second hinge arm wing 3323 of FIG. 10). For example, the electronic device 200 may include a fastening member 390 that penetrates the second housing 230, the second rotator wing 3223, and the second hinge arm wing 3323.

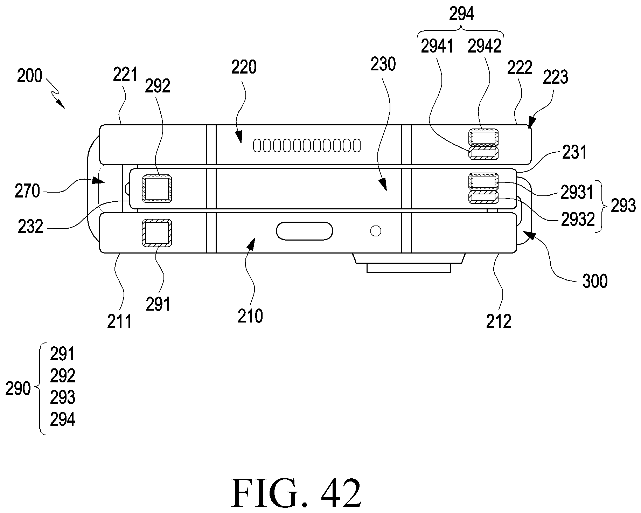

FIG. 41 is a view illustrating a third hinge 304 according to an embodiment of the disclosure. The components to be described with reference to FIG. 41 may be partly or entirely the same as the components described with reference to FIGS. 1 to 40. The components to be described with reference to FIG. 41 may be partially or entirely the same as the components to be described with reference to FIGS. 42 to 45.

According to an embodiment, referring to FIG. 8B, the third hinge 304 may be disposed between the first hinge 302 and the second hinge 303. The third hinge 304 may include a base block 319, a first rotator 321, and a second rotator 322. The first rotator 321 and the second rotator 322 may be rotatably coupled to the base block 319. The base block 319 may be coupled to a hinge housing (e.g., the hinge housing 301 of FIG. 8A). Descriptions of the first rotator 321 and the second rotator 322 may be equally applied to descriptions of the first and second rotators 321 and 322 described with reference to FIGS. 1 to 40. For example, the first rotator 321 may include a first rotator body 3211 and a first rotator wing 3213 that rotates relative to the first rotator body 3211. For example, the second rotator 322 may include a second rotator body 3221 and a second rotator wing 3223 that rotates relative to the second rotator body 3221.

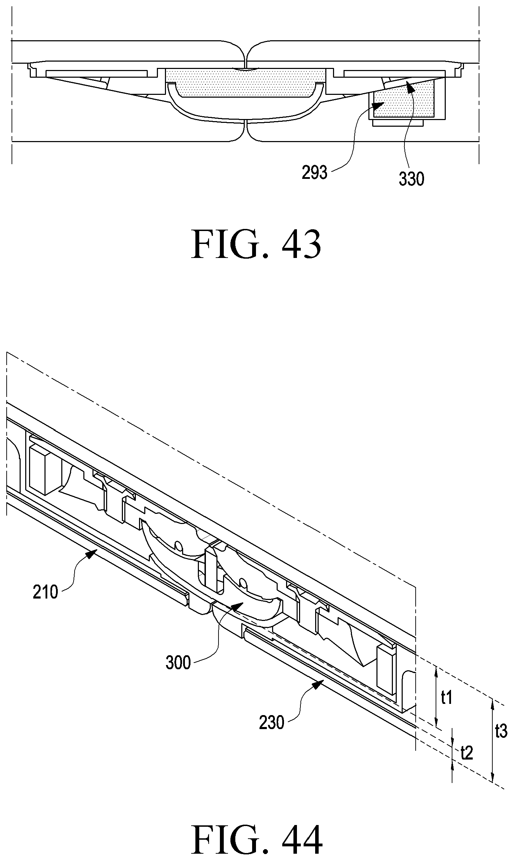

FIG. 42 is a view of the electronic device 200 illustrated in FIG. 4 as viewed in one direction (e.g., the +Y direction). FIG. 43 is a partial cross-sectional view of the electronic device 200. The components to be described with reference to FIGS. 42 and 43 may be partially or entirely the same as the components described with reference to FIGS. 1 to 41. The components to be described with reference to FIGS. 42 and 43 may be partially or entirely the same as the components to be described with reference to FIGS. 44 to 45.

According to an embodiment, the electronic device 200 may include multiple magnets 290. The multiple magnets 290 may be disposed in one of the first housing 210, the second housing 220, or the third housing 230. The multiple magnets 290 may be disposed in the hinge assembly 300.

According to an embodiment, the multiple magnets 290 may include a first magnet 291 disposed in the first housing 210. The multiple magnets 290 may include a second magnet 292 disposed in the third housing 230. The polarity of the first magnet 291 and the polarity of the second magnet 292 may be opposite to each other. In the folded state of the electronic device 200, an attractive force may act between the first magnet 291 and the second magnet 292.

According to an embodiment, the multiple magnets 290 may include a hinge magnet 293. The multiple magnets 290 may include a housing magnet 294. The hinge magnet 293 may be disposed inside the hinge assembly 300. The hinge magnet 293 may be disposed inside the second link assembly 330. The housing magnet 294 may be disposed in the second housing 220. The hinge magnet 293 may include a first hinge magnet portion 2931 and a second hinge magnet portion 2932. The first hinge magnet portion 2931 and the second hinge magnet portion 2932 may have polarities opposite to each other. The housing magnet 294 may include a first housing magnet portion 2941 and a second housing magnet portion 2942. The first housing magnet portion 2941 and the second housing magnet portion 2942 may have polarities opposite to each other.

According to an embodiment, in the folded state of the electronic device 200 as illustrated in FIG. 42, the first hinge magnet portion 2931 and the first housing magnet portion 2941 may be arranged at positions corresponding to each other. The first hinge magnet portion 2931 and the first housing magnet portion 2941 may have polarities opposite to each other. An attractive force may act between the first hinge magnet portion 2931 and the first housing magnet portion 2941.

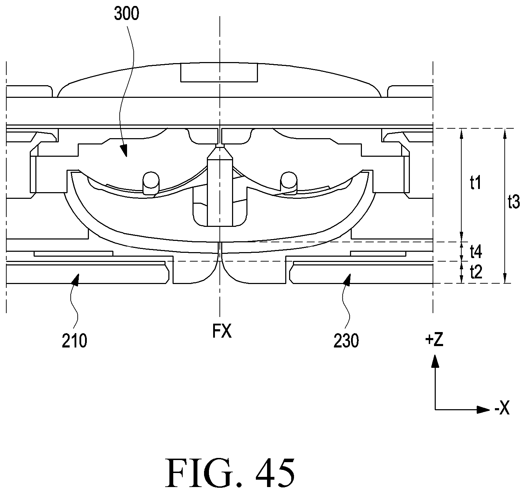

FIG. 44 is a perspective view illustrating an internal structure by partially cutting away the first housing 210 and the second housing 230. FIG. 45 illustrates a portion of the structure of FIG. 44. The components described with reference to FIGS. 44 and 45 may be partially or entirely the same as the components described with reference to FIGS. 1 to 43.

According to an embodiment, the hinge assembly 300 may rotatably connect the first housing 210 and the second housing 230. The first housing 210 and the second housing 230 may be rotated about the folding axis FX. The first housing 210 and the second housing 230 may be rotated about a rotation axis. The rotation axis may be a shaft having a physical shape or may represent the center of a virtual rotational trajectory.

According to an embodiment, the hinge assembly 300 may have a thickness t1 greater than a thickness t2 of the housings 210 and 230. The hinge assembly 300 may be spaced apart from the housings 210 and 230 by a predetermined distance t4.

Due to the structure of the hinge assembly 300 described with reference to FIGS. 1 to 45, the electronic device 200 according to an embodiment of the disclosure may reduce the thickness t1 of the hinge assembly 300. According to an embodiment of the disclosure, by reducing the thickness t1 of the hinge assembly 300, the electronic device 200 may be reduced in a total thickness t3 of structures (e.g., the hinge assembly 300, the first housing 210, and the second housing 230) that support the display 202. According to an embodiment of the disclosure, a sufficient distance t4 may be secured between the hinge assembly 300 and the housings 210 and 230 in the electronic device 200 by reducing the thickness t1 of the hinge assembly 300.

An electronic device may include a first housing and a second housing that are separated from each other. The electronic device may include a hinge assembly that rotatably connects the first housing and the second housing. The hinge assembly may include multiple links in order to facilitate rotational driving of the first housing and the second housing. As a result, the hinge assembly may have an increased thickness occupied inside the electronic device.

A problem to be solved by the disclosure may be to reduce the thickness of the hinge assembly.

A problem to be solved by the disclosure may be to improve the rigidity of the hinge assembly and to reduce misalignment between components constituting the hinge assembly.

The problems to be solved by the disclosure are not limited to the above-mentioned problems, and may be variously defined within a scope that does not depart from the spirit and scope of the disclosure.

The electronic device according to various embodiments of the disclosure may be reduced in the thickness of the hinge assembly by connecting a rotator and a hinge housing through a link and configuring the link to move along a guide of the hinge housing.

The electronic device according to various embodiments of the disclosure may be improved in the rigidity of rotational driving by arranging first and second link assemblies in which multiple components are assembled and by interlocking the first link assembly and the second link assembly through coupling.

The effects that are capable of being obtained by the disclosure are not limited to those described above, and other effects not described above may be clearly understood by a person ordinarily skilled in the art to which the disclosure belongs based on the following description.

According to an embodiment of the disclosure, an electronic device (e.g., 101 in FIGS. 1 to 45) may include a first housing (e.g., 210 in FIGS. 1 to 45).

According to an embodiment of the disclosure, the electronic device (e.g., 101 in FIGS. 1 to 45) may include a second housing (e.g., 230 in FIGS. 1 to 45) disposed to be rotatable with respect to the first housing (e.g., 210 in FIGS. 1 to 45).

According to an embodiment of the disclosure, the electronic device (e.g., 101 in FIGS. 1 to 45) may include a flexible display (e.g., 202 in FIGS. 1 to 45) seated on the first housing (e.g., 210 in FIGS. 1 to 45) and the second housing (e.g., 230 in FIGS. 1 to 45).

According to an embodiment of the disclosure, the electronic device (e.g., 101 in FIGS. 1 to 45) may include a hinge assembly (e.g., 300 in FIGS. 1 to 45) rotatably connecting the first housing (e.g., 210 in FIGS. 1 to 45) and the second housing (e.g., 230 in FIGS. 1 to 45).

According to an embodiment of the disclosure, the hinge assembly (e.g., 300 in FIGS. 1 to 45) may include a hinge housing (e.g., 301 in FIGS. 1 to 45) including a base plate (e.g., 3011 in FIGS. 1 to 45), a first side wall (e.g., 3012a in FIGS. 1 to 45) protruding from the base plate (e.g., 3011 in FIGS. 1 to 45), and a second side wall (e.g., 3012b in FIGS. 1 to 45) protruding from the base plate (e.g., 3011 in FIGS. 1 to 45) and spaced apart from the first side wall (e.g., 3012a in FIGS. 1 to 45).

According to an embodiment of the disclosure, the hinge assembly (e.g., 300 in FIGS. 1 to 45) may include a first rotator (e.g., 321 in FIGS. 1 to 45) coupled to the first housing (e.g., 210 in FIGS. 1 to 45) and rotatably connected to the hinge housing (e.g., 301 in FIGS. 1 to 45).

According to an embodiment of the disclosure, the hinge assembly (e.g., 300 in FIGS. 1 to 45) may include a second rotator (e.g., 322 in FIGS. 1 to 45) coupled to the second housing (e.g., 230 in FIGS. 1 to 45) and rotatably connected to the hinge housing (e.g., 301 in FIGS. 1 to 45).

According to an embodiment of the disclosure, the hinge assembly (e.g., 300 in FIGS. 1 to 45) may include a first link (e.g., 3212 in FIGS. 1 to 45) including a first link part (e.g., 3212e in FIGS. 1 to 45) movably connected to the first rotator (e.g., 321 in FIGS. 1 to 45), a link body (e.g., 3212a in FIGS. 1 to 45) extending from the first link part (e.g., 3212e in FIGS. 1 to 45) toward the hinge housing (e.g., 301 in FIGS. 1 to 45), and a second link part (e.g., 3212f in FIGS. 1 to 45) connected to the link body (e.g., 3212a in FIGS. 1 to 45) and movably disposed between the first side wall (e.g., 3012a in FIGS. 1 to 45) and the second side wall (e.g., 3012b in FIGS. 1 to 45).

According to an embodiment of the disclosure, the first link (e.g., 3212 in FIGS. 1 to 45) may be rotatably coupled to the first rotator (e.g., 321 in FIGS. 1 to 45).

According to an embodiment of the disclosure, the first link (e.g., 3212 in FIGS. 1 to 45) may move toward the first side wall (e.g., 3012a in FIGS. 1 to 45) when the first housing (e.g., 210 in FIGS. 1 to 45) and the second housing (e.g., 230 in FIGS. 1 to 45) move in a direction in which the first and second housings approach each other.

According to an embodiment of the disclosure, the first link (e.g., 3212 in FIGS. 1 to 45) may be engaged with the first side wall (e.g., 3012a in FIGS. 1 to 45) when the angle between the first housing (e.g., 210 in FIGS. 1 to 45) and the second housing (e.g., 230 in FIGS. 1 to 45) is smaller than a first reference value.

According to an embodiment of the disclosure, the hinge assembly (e.g., 300 in FIGS. 1 to 45) may include a guide (e.g., 360 in FIGS. 1 to 45) disposed in the hinge housing (e.g., 301 in FIGS. 1 to 45).

According to an embodiment of the disclosure, the second link part (e.g., 3212f in FIGS. 1 to 45) may move along a surface of the guide (e.g., 360 in FIGS. 1 to 45).

According to an embodiment of the disclosure, the guide (e.g., 360 in FIGS. 1 to 45) may include a guide surface (e.g., 364 in FIGS. 1 to 45) curved toward the first rotator (e.g., 321 in FIGS. 1 to 45).

According to an embodiment of the disclosure, the guide (e.g., 360 in FIGS. 1 to 45) may include a guide body (e.g., 361 in FIGS. 1 to 45) coupled to the hinge housing (e.g., 301 in FIGS. 1 to 45).

According to an embodiment of the disclosure, the guide (e.g., 360 in FIGS. 1 to 45) may include a first guide wall (e.g., 3621 in FIGS. 1 to 45) protruding from the guide body (e.g., 361 in FIGS. 1 to 45).

According to an embodiment of the disclosure, the guide (e.g., 360 in FIGS. 1 to 45) may include a first guide roof (e.g., 3622 in FIGS. 1 to 45) extending in a direction intersecting the first guide wall (e.g., 3621 in FIGS. 1 to 45).

According to an embodiment of the disclosure, the first link (e.g., 3212 in FIGS. 1 to 45) may include a first link protrusion (e.g., 3212b in FIGS. 1 to 45) disposed to be movable between the guide body (e.g., 361 in FIGS. 1 to 45) and the first guide roof (e.g., 3622 in FIGS. 1 to 45).

According to an embodiment of the disclosure, the first link (e.g., 3212 in FIGS. 1 to 45) may include a first link body (e.g., 3212a in FIGS. 1 to 45) including a first link part (e.g., 3212e in FIGS. 1 to 45) and a second link part (e.g., 3212f in FIGS. 1 to 45).

According to an embodiment of the disclosure, the first link (e.g., 3212 in FIGS. 1 to 45) may include a first link shaft (e.g., 3212c in FIGS. 1 to 45) protruding from the first link body (e.g., 3212a in FIGS. 1 to 45) and rotatably inserted into the first rotator (e.g., 321 in FIGS. 1 to 45).

According to an embodiment of the disclosure, the hinge assembly (e.g., 300 in FIGS. 1 to 45) may include a second link (e.g., 3222 in FIGS. 1 to 45) including a (2-1)^{th} link part (e.g., 3222e in FIGS. 1 to 45) movably connected to the second rotator (e.g., 322 in FIGS. 1 to 45) and a (2-2)^{th} link part (e.g., 3222f in FIGS. 1 to 45) disposed to be movable between the first side wall (e.g., 3012a in FIGS. 1 to 45) and the second side wall (e.g., 3012b in FIGS. 1 to 45).

According to an embodiment of the disclosure, the hinge assembly (e.g., 300 in FIGS. 1 to 45) may include a base frame (e.g., 310 in FIGS. 1 to 45) fixed to the hinge housing (e.g., 301 in FIGS. 1 to 45). The first rotator (e.g., 321 in FIGS. 1 to 45) may be rotatably coupled to the base frame (e.g., 310 in FIGS. 1 to 45).

According to an embodiment of the disclosure, the first rotator (e.g., 321 in FIGS. 1 to 45) may include a first rotator body (e.g., 3211 in FIGS. 1 to 45) to which the first link (e.g., 3212 in FIGS. 1 to 45) is movably connected.

According to an embodiment of the disclosure, the first rotator (e.g., 321 in FIGS. 1 to 45) may include a first rotator wing (e.g., 3213 in FIGS. 1 to 45) coupled to the first rotator body (e.g., 3211 in FIGS. 1 to 45) to be relatively rotatable.

According to an embodiment of the disclosure, the first rotator wing (e.g., 3213 in FIGS. 1 to 45) may include a first rotator wing holder (e.g., 3213d in FIGS. 1 to 45) configured to be engaged with the first rotator body (e.g., 3211 in FIGS. 1 to 45).

According to an embodiment of the disclosure, the hinge assembly (e.g., 300 in FIGS. 1 to 45) may include a first link assembly (e.g., 320 in FIGS. 1 to 45) including the first rotator (e.g., 321 in FIGS. 1 to 45), the second rotator (e.g., 322 in FIGS. 1 to 45), and the first link (e.g., 3212 in FIGS. 1 to 45).

According to an embodiment of the disclosure, the hinge assembly (e.g., 300 in FIGS. 1 to 45) may include a second link assembly (e.g., 330 in FIGS. 1 to 45) interlocked with the first link assembly (e.g., 320 in FIGS. 1 to 45) and configured to rotatably connect the first housing (e.g., 210 in FIGS. 1 to 45) and the second housing (e.g., 230 in FIGS. 1 to 45).

According to an embodiment of the disclosure, the second link assembly (e.g., 330 in FIGS. 1 to 45) may include a joint (e.g., 333 in FIGS. 1 to 45) movably disposed in the hinge housing (e.g., 301 in FIGS. 1 to 45) and having a spiral surface.

According to an embodiment of the disclosure, the hinge assembly (e.g., 300 in FIGS. 1 to 45) may include a first spring structure (e.g., 340 in FIGS. 1 to 45) including a first spring (e.g., 342 in FIGS. 1 to 45) configured to be compressed along a longitudinal direction of the hinge housing (e.g., 301 in FIGS. 1 to 45).

According to an embodiment of the disclosure, the hinge assembly (e.g., 300 in FIGS. 1 to 45) may include a first rotator (e.g., 321 in FIGS. 1 to 45) rotatably connected to the hinge housing (e.g., 301 in FIGS. 1 to 45).

According to an embodiment of the disclosure, the hinge assembly (e.g., 300 in FIGS. 1 to 45) may include a second rotator (e.g., 322 in FIGS. 1 to 45) rotatably connected to the hinge housing (e.g., 301 in FIGS. 1 to 45) and spaced apart from the first rotator (e.g., 321 in FIGS. 1 to 45).

According to an embodiment of the disclosure, an electronic device (e.g., 101 in FIGS. 1 to 45) may include a first link (e.g., 3212 in FIGS. 1 to 45) connected to the first rotator (e.g., 321 in FIGS. 1 to 45), in which at least a portion of the first link (e.g., 3212 in FIGS. 1 to 45) is located to be movable between the first side wall (e.g., 3012a in FIGS. 1 to 45) and the second side wall (e.g., 3012b in FIGS. 1 to 45).

According to an embodiment of the disclosure, the first link (e.g., 3212 in FIGS. 1 to 45) may move toward the first side wall (e.g., 3012a in FIGS. 1 to 45) when the first housing (e.g., 210 in FIGS. 1 to 45) and the second housing (e.g., 230 in FIGS. 1 to 45) rotate in a direction in which the first and second housings approach each other.

According to an embodiment of the disclosure, the first link (e.g., 3212 in FIGS. 1 to 45) may be engaged with the first side wall (e.g., 3012a in FIGS. 1 to 45) when a portion of the flexible display (e.g., 202 in FIGS. 1 to 45) seated on the first housing (e.g., 210 in FIGS. 1 to 45) and a portion of the flexible display (e.g., 202 in FIGS. 1 to 45) seated on the second housing (e.g., 230 in FIGS. 1 to 45) are facing each other.

According to an embodiment of the disclosure, the surface of the guide (e.g., 360 in FIGS. 1 to 45) may be curved in a direction away from the base plate (e.g., 3011 in FIGS. 1 to 45).

According to an embodiment of the disclosure, the first link (e.g., 3212 in FIGS. 1 to 45) may include a first link shaft (e.g., 3212c in FIGS. 1 to 45) rotatably inserted into the first rotator (e.g., 321 in FIGS. 1 to 45).

According to an embodiment of the disclosure, the hinge assembly (e.g., 300 in FIGS. 1 to 45) may include a second link (e.g., 3222 in FIGS. 1 to 45) connected to the second rotator (e.g., 322 in FIGS. 1 to 45), in which at least a portion of the second link (e.g., 3222 in FIGS. 1 to 45) is located to be movable between the first side wall (e.g., 3012a in FIGS. 1 to 45) and the second side wall (e.g., 3012b in FIGS. 1 to 45).

In the foregoing detailed description of this document, specific embodiments have been described. However, it will be evident to a person ordinarily skilled in the art that various modifications can be made without departing from the scope of the disclosure.

## Claims

1. An electronic device (101; 200) comprising:
a first housing (210);
a second housing (230) disposed to be rotatable with respect to the first housing (210);
a flexible display (202) seated on the first housing (210) and the second housing (230); and
a hinge assembly (300) rotatably connecting the first housing (210) and the second housing (230), and
wherein the hinge assembly (300) comprises:
a hinge housing (301) including a base plate (3011), a first side wall (3012a) protruding from the base plate (3011), and a second side wall (3012b) protruding from the base plate (3011) and spaced apart from the first side wall (3012a);
a first rotator (321) coupled to the first housing (210) and rotatably connected to the hinge housing (301);
a second rotator (322) coupled to the second housing (230) and rotatably connected to the hinge housing (301); and
a first link (3212) connected to the first rotator (321), wherein at least a portion of the first link (3212) is located to be movable between the first side wall (3012a) and the second side wall (3012b).

2. The electronic device of claim 1,
wherein the first link (3212) comprises:
a first link part (3212e) connected to the first rotator (321);
a link body (3212a) extending toward the hinge housing (301) from the first link part (3212e); and
a second link part (3212f) connected to the link body (3212a) and located to be movable between the first side wall (3012a) and the second side wall (3012b).

3. The electronic device of any one of claims 1 and 2,
wherein the first link (3212) is configured to move toward the first side wall (3012a) when the first housing (210) and the second housing (230) rotate in a direction in which the first and second housings approach each other.

4. The electronic device of any one of claims 1 to 3,
wherein the first link (3212) is configured to be engaged with the first side wall (3012a) when a portion of the flexible display (202) seated on the first housing (210) and a portion of the flexible display (202) seated on the second housing (230) face each other.

5. The electronic device of any one of claims 1 to 4,
wherein the hinge assembly (300) further comprises a guide (360) disposed on the base plate (3011), and
wherein the first link (3212) is configured to move along a surface of the guide (360).

6. The electronic device of claim 5,
wherein the surface of the guide (360) is curved in a direction away from the base plate (3011).

7. The electronic device of any one of claims 5 and 6,
wherein the guide (360) comprises:
a guide body (361) coupled to the hinge housing (301);
a first guide wall (3621) protruding from the guide body (361); and
a first guide roof (3622) extending in a direction intersecting the first guide wall (3621), and
wherein the first link (3212) includes a first link protrusion (3212b) disposed to be movable between the guide body (361) and the first guide roof (3622).

8. The electronic device of any one of claims 1 to 7,
wherein the first link (3212) comprises:
a first link shaft (3212c) rotatably inserted into the first rotator (321).

9. The electronic device of any one of claims 1 to 8,
wherein the hinge assembly (300) further comprises
a second link (3222) connected to the second rotator (322), wherein at least a portion of the second link (3222) is located to be movable between the first side wall (3012a) and the second side wall (3012b).

10. The electronic device of any one of claims 1 to 9,
wherein the hinge assembly (300) further comprises:
a base frame (310) fixed to the hinge housing (301), and wherein the first rotator (321) is rotatably coupled to the base frame (310).

11. The electronic device of any one of claims 1 to 10,
wherein the first rotator (321) comprises:
a first rotator body (3211) to which the first link (3212) is movably connected; and
a first rotator wing (3213) coupled to the first rotator body (3211) to be relatively rotatable.

12. The electronic device of claim 11,
wherein the first rotator wing (3213) includes a first rotator wing holder (3213d) configured to be engaged with the first rotator body (3211).

13. The electronic device of any one of claims 1 to 12,
wherein the hinge assembly (300) further comprises:
a first link assembly (320) comprising the first rotator (321), the second rotator (322) and the first link (3212); and
a second link assembly (330) engaged with the first link assembly (320) and rotatably connecting the first housing (210) and the second housing (230).

14. The electronic device of claim 13,
wherein the second link assembly (330) comprises:
a joint (333) movably disposed in the hinge housing (301) and having a spiral surface.

15. The electronic device of any one of claims 1 to 14,
wherein the hinge assembly (300) further comprises:
a first spring structure (340) including a first spring (342) configured to be compressed along a longitudinal direction of the hinge housing (301).
